(19)

Europäisches
Patentamt
European
Patent Office
Office européen
des brevets

(11) **EP 1 625 780 B1**

(12) **EUROPEAN PATENT SPECIFICATION**

(45) Date of publication and mention
of the grant of the patent:
**18.06.2008 Bulletin 2008/25**

(51) Int Cl.:
***H05K 13/02*** (2006.01)

(21) Application number: **04732484.3**

(22) Date of filing: **12.05.2004**

(86) International application number:
**PCT/JP2004/006682**

(87) International publication number:
**WO 2004/103051 (25.11.2004 Gazette 2004/48)**

(54) **ELECTRONIC COMPONENT FEEDER AND ELECTRONIC COMPONENT FEEDING METHOD**

ZUFUHRUNGSEINRICHTUNG VON ELEKTRONISCHEN BAUTEILEN UND VERFAHREN ZUR
ZUFÜHRUNG VON ELEKTRONISCHEN BAUTEILEN

ALIMENTATION EN COMPOSANTS ELECTRONIQUES ET PROCEDE ASSOCIE

(84) Designated Contracting States:
**DE GB**

(30) Priority: **13.05.2003 JP 2003134237**
**24.09.2003 JP 2003331310**

(43) Date of publication of application:
**15.02.2006 Bulletin 2006/07**

(60) Divisional application:
**06122988.6 / 1 746 874**

(73) Proprietor: **MATSUSHITA ELECTRIC INDUSTRIAL
CO., LTD
Kadoma-shi, Osaka 571-8501 (JP)**

(72) Inventors:
• **ENDO, Tadashi
Fukuoka 818-0041 (JP)**

• **KIDO, Kazuo
Yamanashi 400-0053 (JP)**
• **UCHIDA, Hideki
Nakakoma-gun,
Yamanashi 409-3866 (JP)**
• **OKUDA, Osamu
Fukuoka 818-0024 (JP)**
• **KAKITA, Nobuyuki
Yamanashi 400-0053 (JP)**

(74) Representative: **Eisenführ, Speiser & Partner
Patentanwälte Rechtsanwälte
Postfach 10 60 78
28060 Bremen (DE)**

(56) References cited:
**JP-A- 11 068 384         JP-A- 2001 274 592
JP-A- 2001 326 495     US-A1- 2002 070 570
US-B1- 6 524 052**

**Description**

Technical Field

The present invention relates to an electronic component feeder and an electronic component feeding method for feeding a plurality of electronic components arranged in alignment on a component feed tray to mount the components on a board.

Background Art

Conventionally, there have been known various structures of this kind of electronic component feeder. In such the electronic component feeder, a plurality of pallets, on which a component feed tray (hereinafter referred to as a tray) often used as a feeding system of electronic components to an electronic component mounting apparatus are placed, are loaded stacked in layers (or stacked in tiers) in a magazine. The electronic component feeder, which employs such the conventional magazine, is constructed so as to move up and down the magazine in the vertical direction, or the direction in which the pallets are stacked by means of an elevation unit, position one selected pallet in a pallet unloading position and unload the pallet out of the magazine by means of a pallet unloader. Normally, such a tray unloading is carried out by firstly collecting the pallet on which the used tray is placed by inserting the pallet into the magazine, next moving up or down the magazine by the elevation unit to place the selected one pallet in the unloading position, i.e., a position at the same height level as that of the pallet unloader and then drawing this selected pallet out of the magazine. Subsequently, by picking up (e.g., picking up by suction) each of the electronic components in the tray placed on the pallet unloaded from the magazine by means of the transfer head or the like of the electronic component mounting apparatus.

Moreover, when the electronic components in the tray have been picked up and depleted or in a similar case, the pallet, on which the emptied tray is placed, is replaced by a pallet on which a new tray is placed. However, the above-mentioned pallet replacing work is carried out by the operator's hand, when the operator sometimes sets (loads) the pallet reversely in the lengthwise direction by mistake into the magazine. Since the pallet does not generally have a structure symmetrical in the lengthwise direction, the reversely set pallet cannot produce its function, and this leads to a problem that the electronic component feeder cannot be correctly operated, possibly causing damages of the constituent components of the feeder as well as scattering and damages of the electronic components and so on arranged on the tray.

There has conventionally been developed an electronic component feeder, which can prevent the stop of the electronic component feeder and damages of the constituent components of the feeder due to erroneous setting in the lengthwise direction of the pallet into the magazine.

For example, there is a conventional electronic component feeder, in which the configurations of the edge portion located on the forward side and the edge portion located on the rearward side of each pallet are made different from each other and an engagement member having a configuration that engages with the forward-side edge portion and does not engage with the rearward-side edge portion is arranged on the forward side of the magazine (refer to, for example, Japanese unexamined Patent Publication 11-121985 A). According to the construction of such the conventional electronic component feeder, the erroneous setting of loading the pallet reversely in the lengthwise direction in the magazine can be prevented by the engagement member.

However, the aforementioned structure has a problem that, although the pallet can be prevented from being loaded reversely in the lengthwise direction, when the pallet is loaded correctly in the lengthwise direction even if the pallet is loaded inclined in the magazine, such the erroneous setting cannot be detected (or prevented).

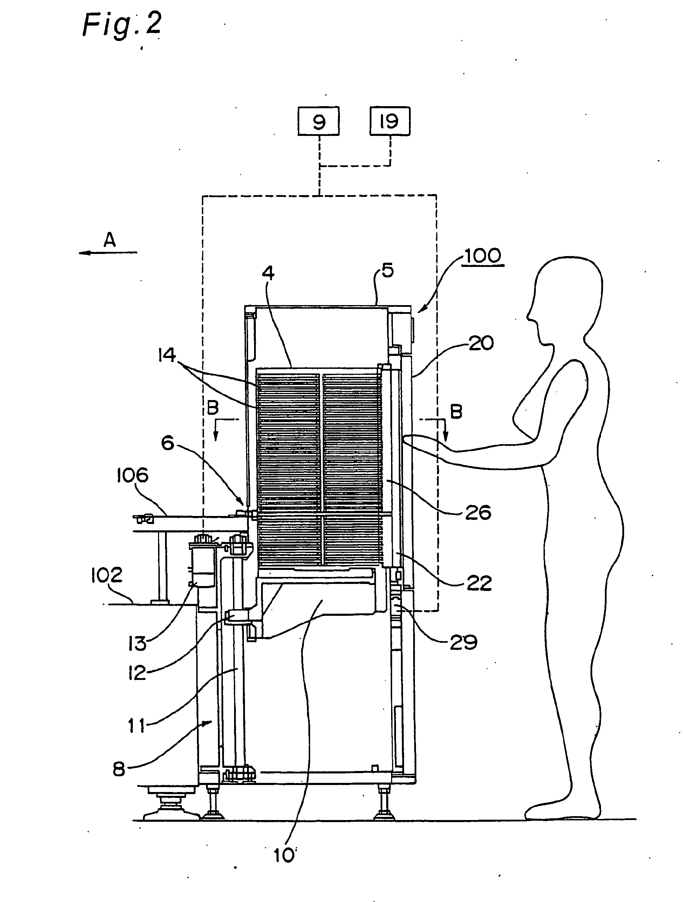

Particularly, with an increasing degree of unfamiliarity with work due to the shifting of the operators themselves and an increasing frequency of the replacement of the pallets in the magazine by the operators as a consequence of an increasing electronic component mounting speed and ongoing diversified small-lot production, there is an increasing number of cases of the erroneous reverse setting in the lengthwise direction and the erroneous inclined setting. Particularly, it is required to insert the pallet (or the magazine itself) while confirming the state of the electronic components, and therefore, the operator naturally turns his or her gaze downward upon the pallet from above (e.g., a positional relation between the operator and the pallet is shown in Fig. 2). In such a situation, the operator, who is concentrating his or her attention on the electronic components, is hardly aware of inclined pallet insertion. Moreover, there is a problem that the possibility of the occurrence of erroneous inclined pallet setting by the operators has been increased because of an increasing number of trays to be loaded in the magazine, i.e., an increasing number of the pallets in accordance with the reductions in size and thickness of the electronic components to be mounted and further with the diversification of the types of the electronic components.

Moreover, in the actual circumferences of the recent growing demands for high-speed and high-efficiency mounting of the electronic components, the operation stop of the electronic component feeder due to the erroneous pallet setting is one of the factors of hindering the achievement of the high speed and high efficiency. Also, for the achievement of the high-speed and high-efficiency mounting of the electronic components, it is demanded to make detectable any erroneous pallet setting in the magazine.

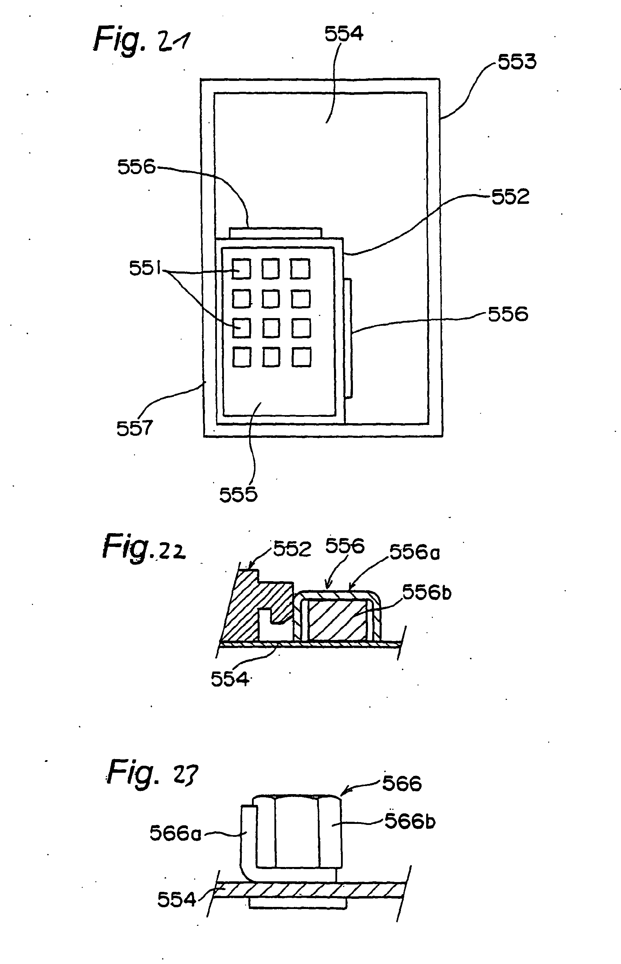

First of all, Fig. 21 shows a schematic plan view of a component feed tray 552 of one example of the tray in which electronic components 551 of such the plurality of electronic components are arranged in alignment for explanation. As shown in Fig. 21, the component feed tray 552, which has a roughly plate-like configuration, is arranged on a tray placement surface 554 that is the upper surface of a tray plate 553 (corresponding to the pallet) that similarly has a roughly plate-like configuration.

Moreover, the component feed tray 552 has a component arrangement region 555 on its upper surface, and the electronic components 551 are arranged in alignment in this component arrangement region 555. Moreover, the component feed tray 552 is arranged at, for example, the lower left-hand corner of the tray placement surface 554 in the drawing and arranged on the tray placement surface 554 with two fixation bars 556 brought in contact with the respective edge portions of the component feed tray 552. With this arrangement, the arrangement of the component feed tray 552 is fixed in directions along the surface of the tray placement surface 554.

In this case, Fig. 22 shows a schematic sectional view showing the cross-sectional structure of this fixation bar 556. As shown in Fig. 22, the fixation bar 556 is a rod-shaped member, which has a roughly C-figured cross section and includes a fixation bar main body 556a that fixes the arrangement position of the component feed tray 552 by being brought in contact with an end portion of the component feed tray 552 and a magnet section 556b fixed inside the C-figured cross section of this fixation bar main body 556a. Moreover, the fixation bar main body 556a can be magnetically releasably connected to the tray placement surface 554 of the tray plate 553 via this magnet section 556b.

Moreover, the end portion of the fixation bar main body 556a brought in contact with the end portion of the component feed tray 552 has an end surface configuration formed roughly perpendicular to the tray placement surface 554. Therefore, as shown in Fig. 22, the fixation bar 556 magnetically fixed on the tray placement surface 554 via the magnet section 556b comes in contact with the end portion of the component feed tray 552, by which the arrangement position of the component feed tray 552 can be fixed in a direction that extends along the surface of the tray placement surface 554 and roughly perpendicular to the direction in which the fixation bar 556 extends.

Moreover, as shown in Fig. 21, by using two fixation bars 556 described the above, the arrangement position of the component feed tray 552 can be fixed in mutually perpendicular two directions in the directions along the surface of the tray placement surface 554. As shown in Fig. 21, peripheral portions 557 of the tray plate 553 are formed protuberant above the tray placement surface 554, and the other two sides in which the two fixation bars 556 are not in contact at the component feed tray 552 are brought in contact with the peripheral portions 557 of the tray plate 553. With this arrangement, the arrangement position is fixed in the aforementioned directions in with the four sides of the component feed tray 552 are surrounded by the peripheral portions 557 of the tray plate 553 and the two fixation bars 556.

Moreover, the conventional fixation bar 556 described the above is not limited to the one that is provided with the magnet section 556b and magnetically fixed on the tray placement surface 554, and fixation bars 556 of various forms are used. For example, as shown in Fig. 23, there is also used a conventional fixation bar 566 having a form such that a rod-shaped fixation bar main body 566a having a roughly L-figured cross-sectional shape is fixed on the tray placement surface 554 by a fastening screw 566b. Even in the case of the fixation bar 566 described the above, the end surface configuration of the end portion to be brought in contact with the end portion of the component feed tray 552 is formed roughly perpendicular to the tray placement surface 554.

However, in the above-mentioned structure, although the arrangement position of the component feed tray 552 is fixed on the tray placement surface 554 of the tray plate 553, the fixation is only effected in the directions along the surface of the tray placement surface 554.

JP 2001-326495 discloses an electronic component supply device which prevents a tray with a cut from being mismounted on a tray base and improves the operability of electronic component mounting operation. The device is equipped with a tray base where a tray with a cut for positioning is positioned and fixed on its top surface. Further, the tray base is equipped with a mismounting preventing member, which is previously arranged where the cut part of the tray is positioned, when the tray is correctly mounted on the tray base. Consequently, an operator is able to visually and easily find that the tray is mismounted on the tray base. By this device only reverse mismounting can be detected, due to the shape of the tray, but inclined mismounting can not be detected.

Disclosure Of Invention

Accordingly, the object of the present invention is to solve the aforementioned problems and provide an electronic component feeder and electronic component feeding method capable of carrying out efficient electronic component feeding by achieving smooth and reliable feeding operation in electronic component feeding for feeding a plurality of electronic components arranged in alignment on a component feed tray for the mounting of the components on a board.

In concrete, by reliably easily detecting the presence or absence of abnormality in the pallet support posture in the magazine and preventing the stop of the electronic component feeder operation and the damage of the constituent components of the feeder attributed to the abnormality in the support posture in the electronic component feeder that feeds the plurality of electronic components arranged in alignment on the component feed tray to an electronic component mounting apparatus, the electronic component feeder capable of achieving the efficient feeding of the electronic components is provided as defined in claim 1. Further, a corresponding electronic component feeding method is provided as defined in claim 17.

According to the first aspect of the present invention, the electronic component feeder is provided with the forward-side regulating member that regulates the support position of the pallets loaded in the magazine by the respective support sections by being brought in contact with the edge portions of the pallets on the forward side in the pallet feed direction and the rearward-side regulating member that is movable along the pallet feed direction and regulates the pallets regulated by the forward-side regulating member by being brought in contact with the edge portions of the pallets on the rearward side in the pallet feed direction. With this arrangement, when the pallets, which are formed so that the edge configuration on the forward side and the edge configuration on the rearward side are different from each other, are loaded in the magazine, it can be detected that the pallet loaded in the reversely directed support posture is included among the loaded pallets on the basis of a difference in the contact position by the rearward-side regulating member.

Furthermore, with the provision of the horizontal posture regulation member, which can be arranged between the pallets loaded in the magazine and regulates the roughly horizontal pallet support posture so as to maintain the support posture by virtue of the above-mentioned arrangement, by arranging the horizontal posture regulation member in the gaps between the pallets, the pallets can be loaded in the magazine without being inclined with the roughly horizontal support posture maintained. Furthermore, when the horizontal posture regulation member cannot be arranged in the gaps due to the contact and consequent interference of the horizontal posture regulation member with any of the pallets, it can be detected that there is included a pallet in the inclined support posture.

Therefore, the abnormality in the support posture of the pallet loaded in the magazine can be detected reliably and easily in the electronic component feeder, and the pallets can consistently be loaded in the correct support posture. Therefore, the occurrence of the operation stop of the electronic component mounting apparatus and damages or the like of the constituent components of the electronic component feeder attributed to the aforementioned pallet support posture can be prevented.

According to the second aspect of the present invention, the magazine door section is provided with the rearward-side regulating member and the horizontal posture regulating member, and the closing of the magazine door section is limited in the aforementioned position where the rearward-side regulating member is brought in contact with the edge portion of the pallet supported in the reversely directed support posture. Moreover, by the limitation of the closing of the magazine door section due to the horizontal posture regulating member brought in contact with the edge portion of the pallet supported by the support sections that are not mutually opposed, it can reliably be detected that the pallet having abnormality in its support posture is included among the pallets loaded in the magazine. Moreover, since the above-mentioned detection can be carried out only by opening or closing the magazine door section, it is possible to carry out the detection more easily and recognizably to the operator.

According to the third aspect of the present invention, it is possible to reliably detect the opening/closing of the magazine door section and reliably make the operator recognize the result by the door opening/closing detection section capable of detecting the open state or the closed state of the magazine door section and the door opening/closing display section that displays the detection result by the door opening/closing detection section recognizably to the operator.

According to another aspect of the present invention, it is possible to regard the opening/closing of the receiver door section, which is opened and closed in accordance with the opening and closing of the magazine door section, as the opening/closing of the magazine door section and to provide the receiver door section with the door opening/closing detection section.

Moreover, by stopping the driving by the magazine elevation unit when the open state of the magazine door section is detected by the door opening/closing detection section, the occurrence of damages or the like of the constituent components of the feeder attributed to the abnormality in the pallet support posture can be prevented beforehand.

Moreover, the horizontal posture regulating member is provided with the plurality of projections to be inserted in the gaps between the pallets. With this arrangement, any projection among the projections interferes with any of the pallets, making it possible to reliably easily detect that the pallet in the inclined support posture is loaded in the magazine.

Moreover, the projections of the horizontal posture regulating member are arranged avoiding the position intermediate between the mutually opposed support sections. With this arrangement, the pallet in the inclined support posture and any of the projections can reliably be made to interfere with each other, allowing the abnormality in the pallet support posture can reliably be detected.

Moreover, the projections are arranged so that any of the projections interferes with the pallet supported by the support sections of which the other support section is displaced by at least one step in the stacking direction with respect to the support section opposed to one support section. With this arrangement, the support posture displaced by one step, which tends to be rather neglected by the operator, can reliably be detected.

Moreover, the pallets having a roughly rectangular shape have a grip portion, which is to unload the pallet and is formed roughly in a protruding configuration at an edge portion located on the forward side in the pallet feed direction, are employed in the magazine, and the rearward-side regulating member is arranged so as to be able to come in contact with the grip portion of the pallet supported in the reversely directed support posture by the support sections. With this arrangement, the forwardly directed support posture and the reversely directed support posture of the pallet can reliably be distinguished and detected by a difference in the position where the pallet is brought in contact with the rearward-side regulating member.

Moreover, the projections of the horizontal posture regulating member are formed with a dimension in length such that the projections do not reach a place above the region where the electronic components are arranged on the tray placed on each of the pallets in the state in which the projections are inserted in the gaps between the pallets. This arrangement is able to reliably prevent interference between the electronic components arranged in alignment in the arrangement region and the projections and reliably prevent the occurrence of damages of the electronic components.

According to the twelfth aspect of the present invention, the component feed tray fixation bar, which releasably fixes the component feed tray on the pallet placement surface in the electronic component feeder, is provided with not only the first direction fixation portion that fixes the placement position of the component feed tray in the first direction, or the direction along the placement surface but also the second direction fixation portion that fixes the placement position of the component feed tray in the second direction roughly perpendicular to the placement surface. With this arrangement, the component feed tray can be fixed in the first direction and the second direction.

If, for example, the case where the component feed tray itself is sucked and held (so-called the erroneous suction) by the component suction and holding member in sucking and holding the component arranged on the thus fixed component feed tray by means of the component suction and holding member occurs, the component feed tray is fixed also in the second direction, and therefore, the occurrence of the uplift of the component feed tray can be prevented beforehand. Accordingly, there can be provided a component feed tray fixation bar capable of preventing the occurrence of the leap-up, displacement in the arrangement position and so on of the components due to the occurrence of the erroneous suction of the component feed tray during the component mounting and contributing to the achievement of efficient component feeding.

Moreover, according to another aspect of the present invention, the first direction fixation portion is the surface (first direction fixation surface) arranged roughly perpendicular to the placement surface, and the second direction fixation portion is the surface (second direction fixation surface) arranged along the placement surface. With this arrangement, by bringing the surfaces in contact (e.g., contact causing surface contact) with the end portions of the component feed tray, the component feed tray can be fixed in the first direction and the second direction.

Moreover, the height position of contact with the end portion of the component feed tray on the second direction fixation surface is adjustable in the second direction. This arrangement can cope with the fixation of component feed trays that have a variety of configurations and allows the fixation to be reliably achieved.

Moreover, the fixation bar is provided with an urging member that consistently urges the second direction fixation portion toward the end portion of the component feed tray along the second direction. With this arrangement, the force of fixation in the second direction can be further improved, allowing more reliable fixation to be achieved. Furthermore, the increased force of fixation can reliably resist the force that tries to uplift the component feed tray due to the erroneous suction of the component feed tray by the component suction and holding member.

Moreover, with the plurality of first direction fixation surfaces and second direction fixation surfaces formed individually in correspondence, the component feed tray can be fixed by selecting the combination of the fixation surfaces corresponding to the configuration (e.g., an end portion formation height and so on) of the component feed tray to be fixed. This arrangement can therefore cope with the fixation of component feed trays that have further diversified configurations.

Moreover, the first direction fixation surface and the second direction fixation surface are the identical fixation surface formed inclined with respect to the placement surface. With this arrangement, the component feed tray can concurrently be fixed in the first direction and the second direction by the identical fixation surface. Therefore, the configuration of the fixation bar can be simplified, and the production workability can be made satisfactory. Furthermore, the fixation is effected by bringing the inclined fixation surface in contact with the end portion of the component feed tray. Therefore, it becomes possible to achieve the above-mentioned contact without being influenced by the formation height of the end portion, and this can cope with the fixation of component feed trays that have diversified forms.

Moreover, since the fixation bar is provided with the magnetic member, the fixation bar can be fixed in the desired position of the placement surface by the magnetic force of the magnetic member. This allows the handlability of the fixation bar to be satisfactory and reliable fixation to be achieved regardless of the configuration of the component feed tray to be fixed.

Brief Description of Drawings

These and other aspects and features of the present invention will become clear from the following description taken in conjunction with the preferred embodiments thereof with reference to the accompanying drawings, in which:

Fig. 1 is an external perspective view of an electronic component mounting apparatus provided with an electronic component feeder according to a first embodiment of the present invention;

Fig. 2 is a schematic cross-sectional view showing a schematic structure of the electronic component feeder of Fig. 1;

Fig. 3 is a schematic perspective view of a tray and a pallet handled by the electronic component feeder;

Fig. 4 is a schematic sectional view (showing the normal loading state of the pallets) of a cross section perpendicular to a pallet feed direction of a magazine;

Fig. 5 is a cross-sectional view taken along the line B-B (showing the normal loading state of the pallets) of the electronic component feeder of Fig. 2;

Fig. 6 is a sectional view showing a state in which an outer door and an inner door are opened at the electronic component feeder of Fig. 5;

Figs. 7A and 7B are schematic sectional views of a large-size magazine in a direction perpendicular to the pallet feed direction, showing a state in which a pallet in an inclined support posture is included, where Fig. 7A shows a state in which the pallet is supported by rack portions shifted by two steps, and Fig. 7B shows a state in which the pallet is supported by rack portions shifted by one step;

Figs. 8A and 8B are schematic sectional views of a small-size magazine in a direction perpendicular to the pallet feed direction, showing a state in which the pallet in an inclined support posture is included, where Fig. 8A shows a state in which the pallet is supported by rack portions shifted by two steps, and Fig. 8B shows a state in which the pallet is supported by rack portions shifted by one step;

Fig. 9 is a view corresponding to the sectional view of the electronic component feeder of Fig. 4, showing a state in which the pallet is loaded in a reversely directed support posture;

Fig. 10 is a view corresponding to the sectional view of the electronic component feeder of Fig. 4, showing a state in which the pallet is loaded in an inclined support posture;

Fig. 11 is a schematic partial sectional view of a cross section of the small-size magazine in the direction perpendicular to the pallet feed direction;

Fig. 12 is a schematic partial sectional view of a cross section of the large-size magazine in the direction perpendicular to the pallet feed direction;

Figs. 13A and 13B are schematic views of a tray plate provided with fixation bars used in an electronic component feeder according to a second embodiment of the present invention, where Fig. 13A shows a plan view, and Fig. 13B shows a side view;

Figs. 14A and 14B are schematic views of a state in which a component feed tray is fixed on the tray plate of Figs. 13A and 13B by means of fixation bars, where Fig. 14A shows a plan view, and Fig. 14B shows a side view;

Fig. 15 is a schematic sectional view of the fixation bar of Figs. 13A and 13B;

Fig. 16 is a schematic explanatory view showing a force generated when an attractive force is imposed on the component feed tray fixed by the fixation bar of Figs. 13A and 13B;

Fig. 17 is a sectional view of a fixation bar according to a first modification example of the fixation bar of Fig. 15;

Fig. 18 is a sectional view of a fixation bar according to a second modification example of the fixation bar of Fig. 15;

Fig. 19 is a sectional view of a fixation bar according to a third modification example of the fixation bar of Fig. 15;

Figs. 20A and 20B are schematic views of a tray plate according to the modification example of the tray plate of Figs. 13A and 13B, where Fig. 20A shows a plan view, and Fig. 20B shows a side view;

Fig. 21 is a schematic plan view of a conventional tray plate;

Fig. 22 is a schematic sectional view of a conventional fixation bar;

Fig. 23 is a schematic sectional view of a fixation bar according to another conventional example; and

Fig. 24 is a sectional view of a fixation bar according to a modification example of the fixation bar of Fig. 15.

Best Mode for Carrying Out the Invention

Before the description of the present invention proceeds, it is to be noted that like components are designated by like reference numerals throughout the accompanying drawings.

(First Embodiment)

The first embodiment of the present invention will be described in detail below with reference to the drawings. '

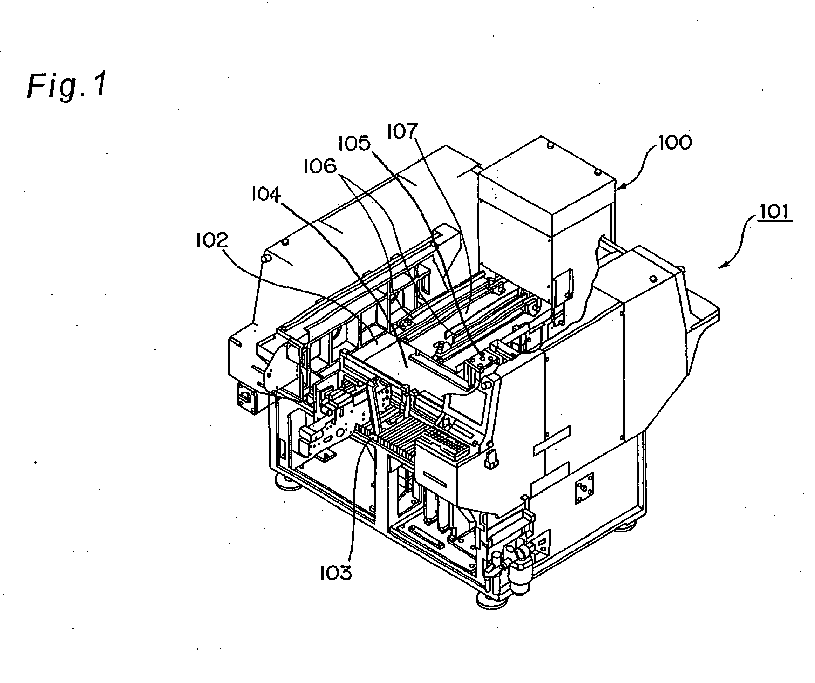

Fig. 1 shows an external perspective view (illustrated partially transparently) of an electronic component mounting apparatus 101 provided with an electronic component feeder 100 according to the first embodiment of the present invention.

As shown in Fig. 1, the electronic component mounting apparatus 101, which carries out component mounting for mounting a plurality of fed electronic components onto a circuit board, is provided with the electronic component feeder 100 (this may be referred to as a tray component feeder) that feedably accommodates a plurality of electronic components arranged in alignment on a tray removably on the illustrated rearward side of a machine base 102 of the electronic component mounting apparatus 101 and provided with a tape-carried component feeder 103, which feeds a plurality of tape-carried electronic components accommodated arranged in alignment in a line and is located on the illustrated frontward side of the machine base 102. The tape-carried component feeder 103 mainly feeds electronic components of small-size chip components and so on, while the electronic component feeder 101 feeds electronic components of a size comparatively larger than the chip components and electronic components that have specific shapes, such as IC components of, for example, QFP (Quad Flat Package) and BGA (Ball Grid Array) and so on.

As shown in Fig. 1, the electronic component mounting apparatus 101 has a stage 104, that is arranged in a roughly center portion of the machine base 102, for fixing a circuit board fed to the electronic component mounting apparatus 101 releasably and a head section 105. for mounting each of electronic components fed from the electronic component feeder 100 or the tape-carried component feeder 103 onto the circuit board fixed on the stage 104. An unloader 106 for unloading the tray, which is removably loaded in the electronic component feeder 100, for bringing each of the electronic components arranged on the unloaded tray into a state in which each of the components can be picked up by the head section 105 is provided on the machine stand 102 located between the electronic component feeder 100 and the stage 104. It is to be noted that the position in which the tray unloaded by this unloader 106 is arranged is an electronic component feed position 107.

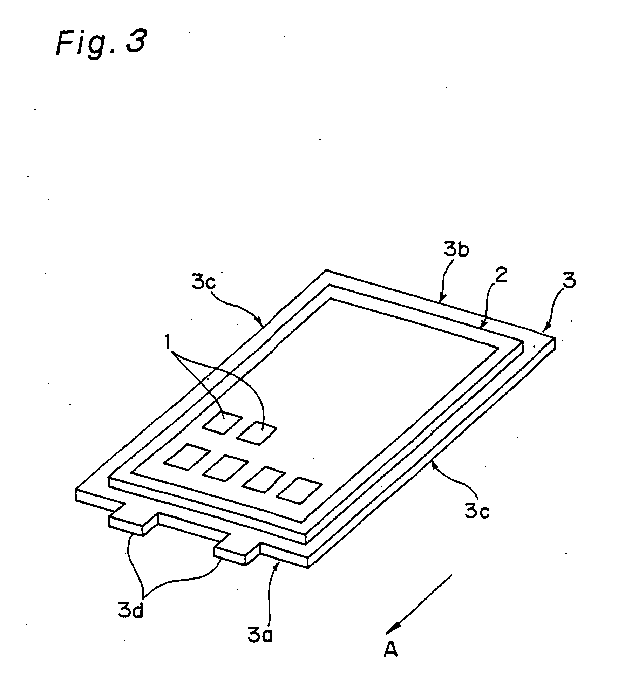

Next, a longitudinal sectional view showing the schematic structure of the electronic component feeder 100 is shown in Fig. 2. Fig. 3 shows a schematic perspective view of the tray loaded in the electronic component feeder 100.

As shown in Fig. 3, a plurality of electronic components 1 are arranged in alignment on the upper surface of a tray 2 that has a roughly quadrangular plate-like shape. The tray 2 is placed on the upper surface of a pallet 3 that has a roughly quadrangular plate-like shape. A plurality of pallets 3 on each of which the tray 2 is thus placed are loaded in a stack vertically at regular intervals in the electronic component feeder 100.

As shown in Fig. 2, the electronic component feeder 100 has a magazine 4 that is a box to be loaded with a plurality of pallets 3 in a stack as described above and a main body section 5 that is a box-shaped casing that receives this magazine 4 elevatably along the inside thereof and serves as one example of the magazine receiver.

Moreover, as shown in Fig. 2, the main body section 5 of the electronic component feeder 100 is arranged adjacently to the machine base 102 of the electronic component mounting apparatus 101. A pallet feed port 6, which is an opening to unload the pallet 3 by the unloader 106 arranged on the machine base 102, is provided on the left-hand side in the figure, and the pallet 3 can be unloaded from inside the magazine 4 through this pallet feed port 6 by the unloader 106. In Fig. 2, the leftward direction in the figure is the unloading direction of each pallet 3 by the unloader 106, i.e., a pallet feed direction A.

Moreover, as shown in Fig. 2, the electronic component feeder 100 has a magazine elevation unit 8 for moving up and down the magazine 4 inside the main body section 5. The magazine elevation unit 8 has a magazine support base 10 for supporting the magazine 4 in its lower portion, a ball screw shaft section 11 that is arranged in the vertical direction in the figure and is fixed to the main body section 5 rotatably around the axis thereof, a nut section 12 that is meshed with this ball screw shaft section 11 and fixed to the magazine support base 10 and an elevation drive motor 13 for driving the rotation of the ball screw shaft section 11 around the axis selectively in either the forward or reverse rotational direction. By rotating the elevation drive motor 13 in either the forward or reverse rotational direction, the nut section 12 can be moved up or down along the ball screw shaft section 11, by which the magazine 4 supported on the magazine support base 10 can be moved up and down along the inside of the main body section 5. When selected one pallet 3 is unloaded from among the pallets 3 loaded in the magazine 4, by moving up and down the magazine 4 by the magazine elevation unit 8 so that the selected pallet 3 is located in the height position of the pallet feed port 6, the pallet 3 located in the height position can be unloaded through the pallet feed port 6 by the unloader 106.

Moreover, as shown in Fig. 2, a plurality of rack sections 14, which is one example of the support section that has a recessed cross-sectional configuration, are formed with a constant spacing pitch in the vertical direction on the mutually opposed inner side surfaces of the magazine 4 in a direction perpendicular to the pallet feed direction A (i.e., direction perpendicular to the sheet plane of Fig. 2). The rack sections 14 are formed in a groove-like form so as to extend along the pallet feed direction A on the inner side surfaces of the magazine 4 and able to support the edge portions of the pallet 3 on the mutually opposed rack sections 14, i.e., a pair of rack sections 14 and to move the pallet 3 in the supported state in a direction in which the rack sections 14 are formed, i.e., along the pallet feed direction A.

Here is described more in detail the structure of the pallet 3 referring back to Fig. 3. As shown in Fig. 3, the edge portions in the direction perpendicular to the pallet feed direction A out of the four edge portions of the pallet 3 serve as support side edge portions 3c movably supported by a pair of rack sections 14 of the magazine 4 as described above. The edge portion of the pallet 3 located on the forward side (on this side in the figure) in the pallet feed direction A serves as a forward side edge portion 3a, and protruding grip portions 3d to grip the pallet 3 by the unloader 106 are formed at the forward side edge portion 3a. The edge portion of the pallet 3 located on the rearward side (far side in the figure) in the pallet feed direction A serves as a rearward side edge portion 3b.

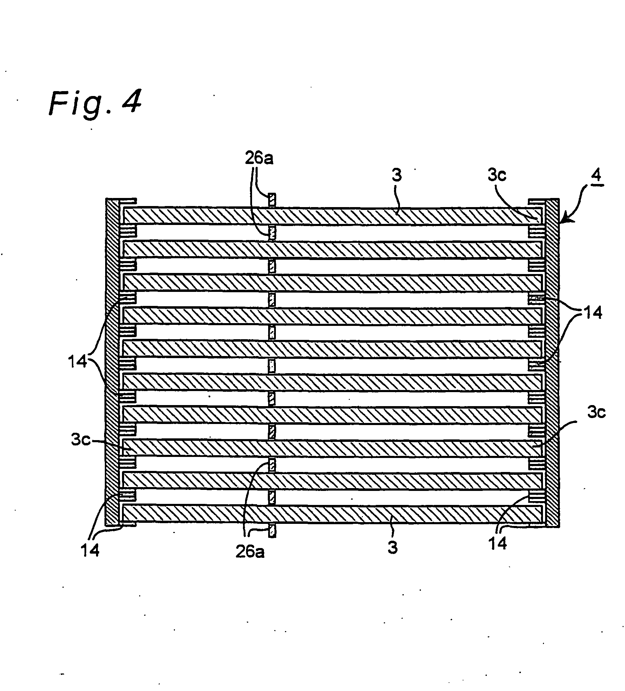

Fig. 4 shows a schematic partial sectional view of the cross section perpendicular to the pallet feed direction A of the magazine 4 in a state in which the pallets 3 are supported and loaded on the respective rack sections 14. As shown in Fig. 4, the support side edge portions 3c of the pallets 3 are supported in an engagement manner by the mutually opposed respective rack sections 14 in the magazine 4. In the above-mentioned state, the pallets 3 are stacked at the aforementioned regular intervals without being put in contact with one another with the roughly horizontal support postures thereof maintained with interposition of constant gaps.

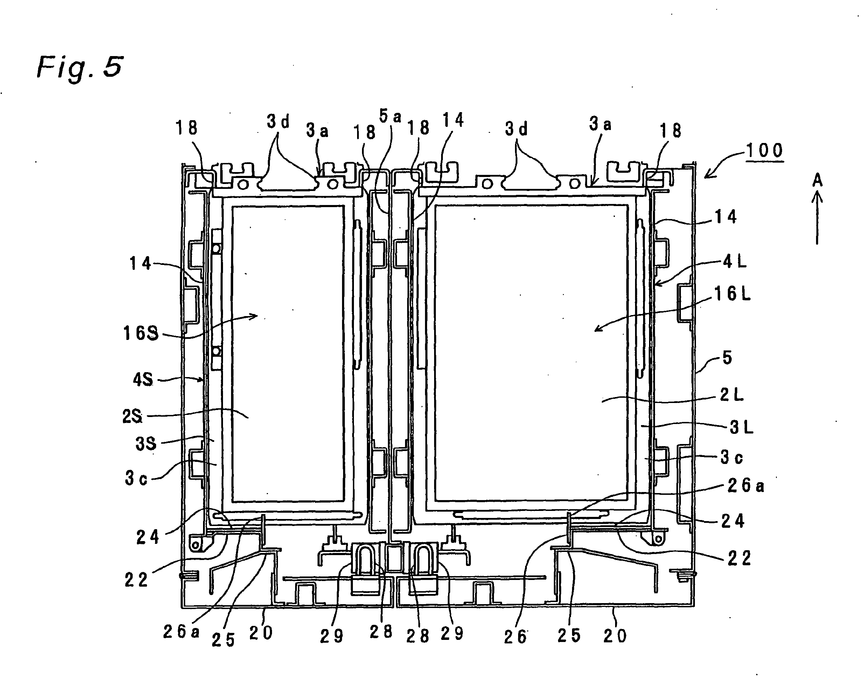

Next, a cross-sectional view taken along the line B-B of the electronic component feeder 100 of Fig. 2 is shown in Fig. 5. Although the state in which no pallet 3 is loaded in the magazine 4 is shown in the electronic component feeder 100 of Fig. 2, Fig. 5 shows a state in which the pallets 3 are loaded in the magazine 4 for the sake of easy understanding of the following description.

As shown in Fig. 5, two magazines 4 are mutually adjacently received in the main body section 5 of the electronic component feeder 100. A plurality of large-size pallets 3L on which large-size trays 2L are placed are loaded in a large-size magazine 4L located on the right-hand side in the figure, while a plurality of small-size pallets 3S on which small-size trays 2S are placed are loaded in a small-size magazine 4S located on the left-hand side in the figure. The magazines 4L and 4S can be individually moved up and down by mutually independent magazine elevation units 8.

Although an example in which two types of magazines 4 are received in the main body section 5 will be described in connection with the present embodiment, the present embodiment is not limited to this case but allowed to be applied to the case where only one type of magazine 4 is received or the case where three or more types of magazines 4 are received instead of the above-mentioned case.

In the following description, the large-size magazine 4L or the small-size magazine 4S is referred to as the magazine 4 when not limitedly used, and similarly, the large-size pallet 3L or the small-size pallet 3S is referred to as the pallet 3 when not limitedly used.

As shown in Fig. 5, the main body section 5 has an inner wall 5a. With this inner wall 5a served as a boundary, a large-size magazine receiving chamber 16L for receiving the large-size magazine 4L is formed on the right-hand side in the figure, and a small-size magazine receiving chamber 16S for receiving the small-size magazine 4S is formed on the left-hand side in the figure.

Moreover, as shown in Fig. 5, the large-size magazine receiving chamber 16L has forward guide sections 18 of one example of the forward-side regulating member for coming in contact with the neighborhood of both end portions of the forward side edge portion 3a of the large-size pallet 3L loaded in the magazine 4L and to regulate the movement position (or support position) on the forward side in the pallet feed direction of the large-size pallet 3L by the contact. Moreover, the forward guide sections 18, which are fixed to the main body section 5 so as to extend along the entire length in the vertical direction within the range of elevation of the large-size magazine 4L, are not provided in the portions corresponding to the pallet feed port 6 for unloading each pallet 3. It is to be noted that the small-size magazine receiving chamber 16S is similarly provided with forward guide sections 18.

Moreover, as shown in Fig. 5, the rearward side of the main body section 5 in the pallet feed direction A serves as the pallet loading side for carrying out loading, replacement or the like of each pallet 3, and the main body section 5 has two outer doors 20, which serve as one example of an openable receiver door section, on this pallet loading side. The outer doors 20 can be opened on both sides of the placement position of the inner wall 5a served as a boundary, and only one outer door 20 can be selectively opened independently. For example, when only the outer door 20 located on the right-hand side in the figure is opened, only the large-size magazine receiving chamber 16L can be opened.

On the rearward side in the pallet feed direction A, each magazine 4 has an inner door 22 of one example of the openable magazine door section for carrying out loading or the like of the pallets 3 in the magazine 4. Each of the inner doors 22 is formed so as not to cover the entire rearward side surface of the magazine 4 in the pallet feed direction A but to cover only about one third of the surface.

Further, the inner doors 22 of the large-size magazine 4L are internally provided with a rearward guide section 24, which is one example of the rearward-side regulating member for regulating the movement position (or support position) on the rearward side in the pallet feed direction A by being brought in contact with the rearward side edge portion 3b of each of the large-.size pallets 3L loaded in the magazine 4L loaded in the large-size magazine receiving chamber 16L. This rearward guide section 24 is formed on the inner door 22 so as to extend from the upper end to the lower end of the magazine 4L in the vertical direction and is movable along the pallet feed direction A in accordance with the pivoting of the inner door 22. Further, in the magazine 4L, the inner door 22 is closed in a state in which both end portions of the forward side edge portion 3a of the large-size pallet 3L are brought in contact with the forward guide sections 18 and its movement position in the pallet feed direction A is regulated and in a state in which the rearward guide section 24 is brought in contact with the rearward side edge portion 3b of the large-size pallet 3L (i.e., the state shown in Fig. 5). Further, a bumper section 25 for bumping against the outside of the corresponding inner door 22 is formed inside the outer door 20, so that the outer door 20 can be completely closed with the bumper section 25 brought in contact with the outside of the inner door 22 only in a state in which the inner door 22 is completely closed as described above. Therefore, the outer door 20 is constructed unclosable in a state in which the corresponding inner door 22 is not completely closed, since the bumper section 25 is brought in contact with the outside of inner door 22 that is not closed and the pivotal position of the outer door 20 is regulated. It is to be noted that a rearward guide section 24 is similarly provided inside the inner door 22 of the small-size magazine 4S.

Moreover, as shown in Figs. 2, 4 and 5, a combteeth-shaped combteeth guide section 26 (one example of the horizontal posture regulating member), which has a plurality of projections 26a vertically arranged at the same formation interval as the formation interval of the rack sections 14, is provided inside each of the inner doors 22. The projections 26a in the combteeth guide section 26 can be arranged so as to be inserted in gaps between the pallets 3 loaded stacked in the magazine 4. In concrete, by closing the inner door 22 of the magazine 4L loaded with the large-size pallets 3L, the projections 26a can be inserted in the gaps between the large-size pallets 3L. As described above, it can be detected whether or not the large-size pallets 3L are each securely supported by a pair of mutually opposed rack sections 14, i.e., whether or not the large-size pallets 3L are each supported in a roughly horizontal support posture in the magazine 4 by inserting the projections 26a in the gaps.

Moreover, as shown in Fig. 4, each of the projections 26a of the combteeth guide section 26 has the height, so that each projection 26a is slightly smaller than the height dimension of the gap between the large-size pallets 3L in the stacked state, so that none of the projections 26a is brought in contact with the large-size pallets 3L when the large-size pallets 3L are each loaded in the state in which the roughly horizontal support posture is maintained.

Further, as shown in Fig. 5, each of the projections 26a has a length in the pallet feed direction A, so that the projection does not reach the region where the electronic components 1 in the large-size tray 2L placed on the large-size pallet 3L are arranged even in a state in which the projection 26a is arranged inserted between the large-size pallets 3L. Therefore, even in the case where electronic components 1 having an especially large height are arranged in the large-size tray 2L and the large-size tray 2L is placed on the large-size pallet 3L and loaded in the magazine 4L, the fore ends of the projections 26a of the combteeth guide section 26 do not come in contact with the electronic components 1 arranged in the large-size tray 2L, reliably preventing the occurrence of damages of the electronic components 1 due to the contact.

Moreover, as shown in Fig. 5, the combteeth guide sections 26 are arranged closer to the rack section 14 located on the right-hand side with respect to the position roughly intermediate between mutually opposed rack sections 14 in the magazine 4L, while the combteeth guide sections 26 are arranged closer to the rack section 14 located on the left-hand side with respect to the position roughly intermediate between mutually opposed rack sections 14 in the magazine 4S. The combteeth guide sections 26 are formed so as to extend from the upper end to the lower end of the magazine 4. Moreover, the combteeth guide sections 26 inserted between the large-size pallets 3L are provided on the inner door 22 of the large-size magazine 4L. With this arrangement, the combteeth guide sections 26 are moved up and down together with the large-size pallets 3L even if the large-size magazine 4L is moved up and down by the magazine elevation unit 8, and therefore, the elevation operation of the large-size magazine 4L is not hindered.

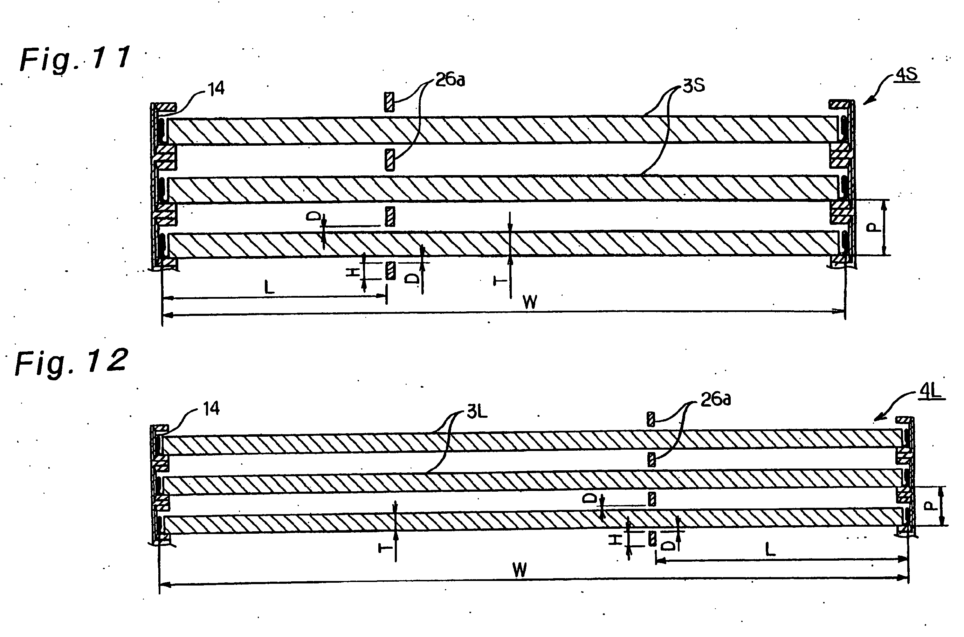

In this case, one example of the dimensions of the combteeth guide sections 26 is shown in Fig. 11 (a schematic partial sectional view of a cross section perpendicular to the pallet feed direction A) with regard to the small-size magazine 4S and in Fig. 12 (a schematic partial sectional view of a section similar to the above) with regard to the large-size magazine 4L. As shown in Fig. 11, in the small-size magazine 4S, the dimensions are set so that a width W between a pair of rack sections 14 is 170 mm, a interval (pitch) P of the rack sections 14 is 13.5 mm, a thickness T of the small-size pallet 3S is 6 mm, a height H of the projection 26a of the combteeth guide section 26 is 4.5 mm, a gap height D of a space between the upper surface or the lower side of the small-size pallet 3S and the nearmost projection 26a is 1.5 mm, and a distance L between each projection 26a and the rack section 14 (rack section 14 located on the adjacent side) is 56 mm. Moreover, as shown in Fig. 12, in the large-size magazine 4L, the dimensions are set so that a width W between a pair of rack sections 14 is 260 mm, a interval (pitch) P of the rack sections 14 is 13.5 mm, a thickness T of the large-size pallet 3L is 6 mm, a height H of the projection 26a of the combteeth guide section 26 is 4.5 mm, a gap height D of the space between the upper surface or the lower side of the large-size pallet 3L and the nearmost projection 26a is 1.5 mm, and a distance L between each projection 26a and the rack section 14 (rack section 14 located on the adjacent side) is 87 mm. It is preferable to set the distance L between each projection 26a and the rack section 14 to a dimension about one third of the width W between a pair of rack sections 14 (i.e., L = 1/3W or a dimension about one third of the width of the pallet 3) for the reasons described later.

Further, as shown in Fig. 5, each of the outer doors 20 is provided with a door opening/closing detection. section for detecting the opening or closing of the outer door 20, and this door opening/closing detection section has a safety switch dog 28 provided in a lower portion of the open side end portion of each outer door 20 and a safety switch 29 engaged with the safety switch dog 28 in a state in which each outer door 20 is completely closed.

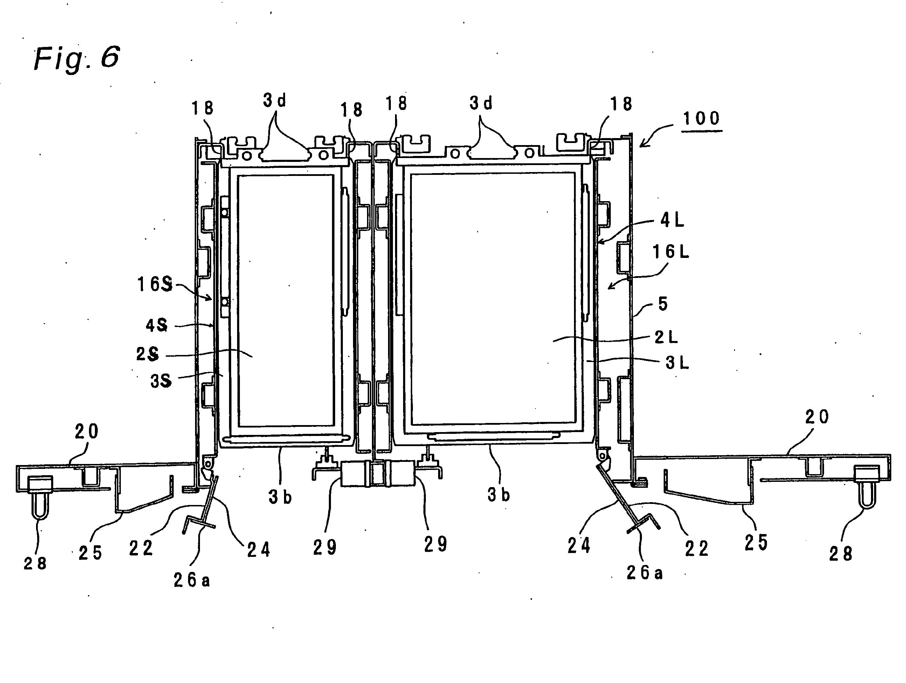

Fig. 6 shows a state in which the outer doors 20 and the inner doors 22 are opened at the electronic component feeder 100. In this state, the regulation of the movement position on the rearward side in the pallet feed direction A of the pallets 3 (i.e., the large-size pallets 3L and the small-size pallets 3S) loaded in the magazines 4L and 4S are released. Therefore, it is possible to carry out replacement of each pallet 3 by unloading, loading of a new pallet 3 and so on.

Moreover, as shown in Fig. 2, the electronic component feeder 100 has a control unit 9, for controlling the elevation operation of the magazines 4 by the respective magazine elevation units 8 and the detection of the open/ closed state of each of the outer doors 20 by the respective safety switches 29 and safety switch dogs 28. The control unit 9 can execute the above-mentioned control operations in correlation with the control operation of a mounting control unit that controls the mounting operation of the electronic components 1 in the electronic component mounting apparatus 101.

In concrete, the control unit 9 can execute, for example, the control of the elevation operation by the magazine elevation unit 8 so that one pallet 3 loaded in the magazine 4 of the electronic component feeder 100 is selected according to the type of the electronic component 1 to be mounted on a circuit board and the selected pallet 3 is positioned in the height position of the pallet feed port 6 and putting the pallet 3 positioned in the height position into an unloadable state by the unloader 106.

Moreover, there is provided an interlock that stops the elevation operation by the magazine elevation unit 8 when the open state of the outer door 20 is detected by either the safety switch 29 or the safety switch dog 28 on the assumption that the loading state (support posture) of the pallet 3 loaded in either of the magazines 4L or 4S is abnormal. There is further provided a display section 19 that operates, when the open state of the outer door 20 as described above is detected, to display the information of the event while allowing the operator to recognize the information.

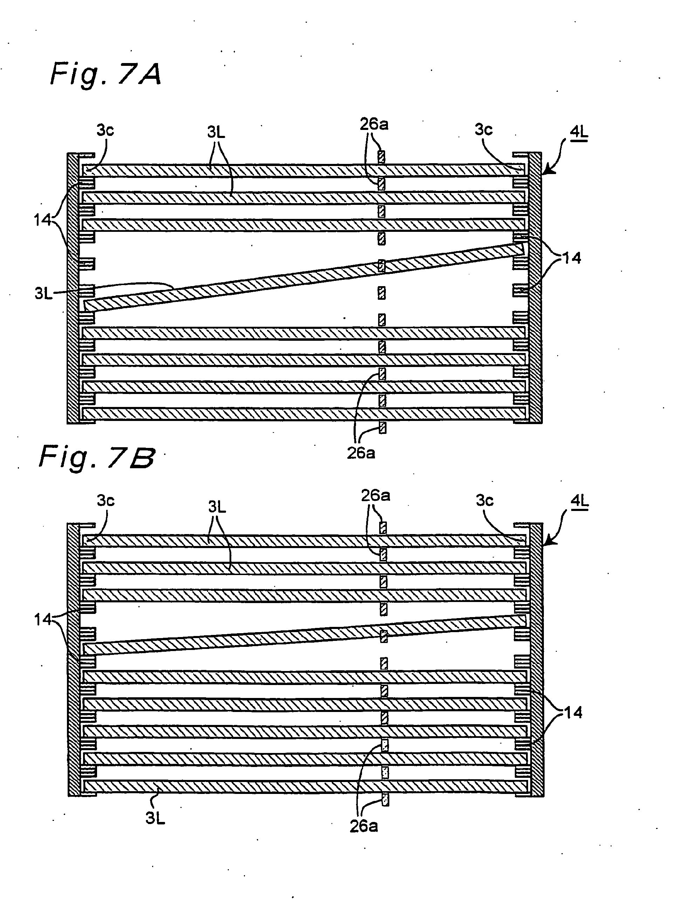

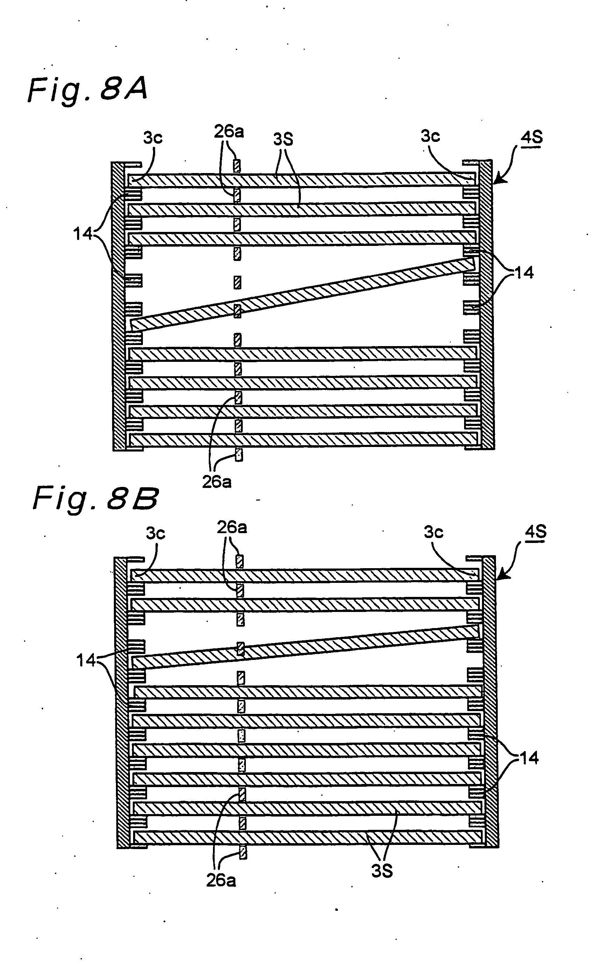

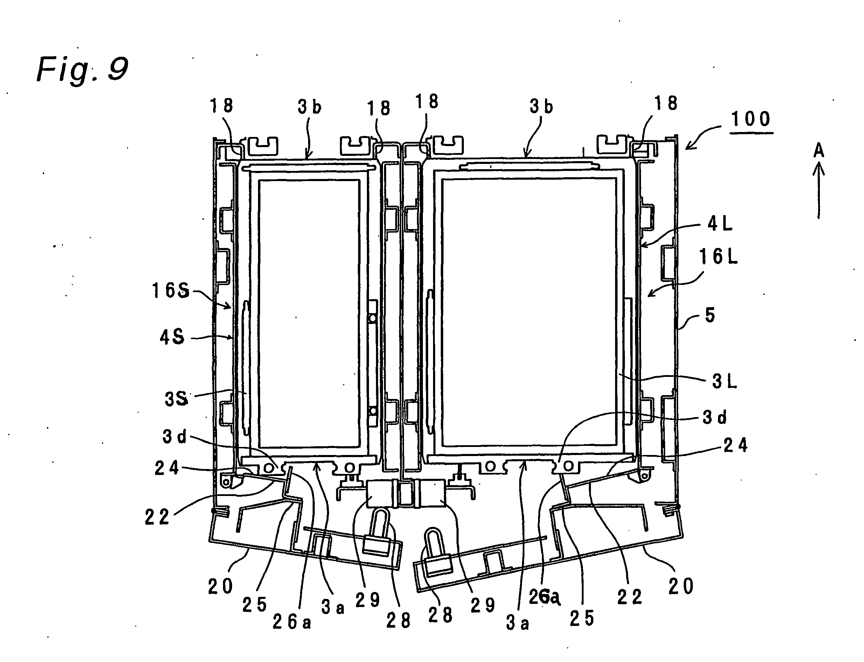

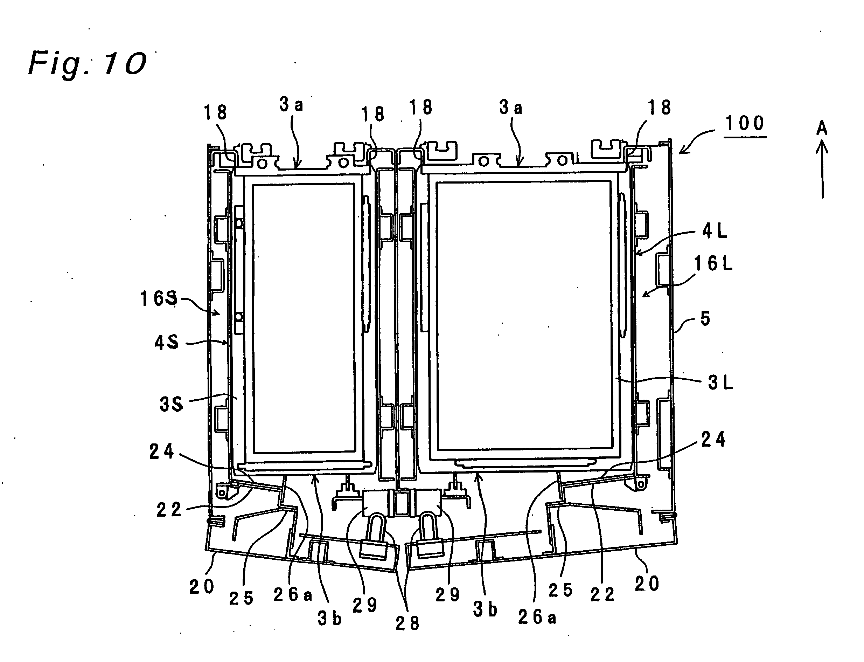

A method for detecting the occurrence of abnormality in the support posture (or loading posture) of the pallet 3 loaded in the magazine 4 in the electronic component feeder 100 of the aforementioned construction will be described below by way of a concrete example. Figs. 7A and 7B show schematic sectional views of a cross section perpendicular to the pallet feed direction A of the large-size magazine 4L in which the pallet 3 having the aforementioned abnormality in the support posture is loaded, while Figs. 8A and 8B show schematic sectional views of the small-size magazine 4S. Figs. 9 and 10 show schematic sectional views of a cross section perpendicular to the stacking direction of the pallet 3 in the electronic component feeder 100 in such the state.

First of all, Figs. 4 and 5 show a state in which the pallets 3 are loaded in the normal support posture in the magazine 4 of the electronic component feeder 100. There are two requirements for the loaded pallet 3 to keep this normal support posture in the magazine 4. As the first requirement, the forward side edge portion 3a of the pallet 3 is required to be directed in the pallet feed direction A (this arrangement is referred to as a forwardly directed support posture in the pallet feed direction A) as shown in Fig. 5. Further, as the second requirement, the support side end portions 3c of the pallet 3 are required to be supported by a pair of mutually opposed rack sections 14, i.e., in the state in which the roughly horizontal support posture is maintained as shown in Fig. 4. If either one of the above-mentioned requirements is not satisfied, the pallet 3 is loaded not in the correct support posture, and there is abnormality in the support, posture. In the above case, there possibly occur not only hindrance in the elevation operation of the magazine 4 by the magazine elevation unit 8 and the unloading operation of the pallet 3 by the unloader 106 but also the damage of the pallet 3 and the electronic component feeder 100 itself due to the operation.

As shown in Fig. 9, in the small-size magazine receiving chamber 16S in the electronic component feeder 100, the forward side edge portion 3a of the small-size pallet 3S is arranged so as to direct in the direction reverse to the pallet feed direction A (i.e., this posture is referred to as a reversely directed support posture in the pallet feed direction A). In concrete, end portions of the rearward side edge portion 3b of the small-size pallet 3S are brought in contact with the forward guide sections 18, so that the support position on the forward side in the pallet feed direction A is regulated by this contact. If it is tried to close the inner door 22 of the small-size magazine 4S in the above-mentioned state, the protruding grip portion 3d formed at the forward side edge portion 3a of the small-size pallet 3S is brought in contact with the rearward guide section 24 provided inside the inner door 22, as a consequence of which the position where the small-size pallet 3S is brought in contact with the rearward guide section 24, i.e., the pivotal position of the inner door 22 is limited and put into the unclosable state. Further, the bumper section 25 of the outer door 20 (outer door 20 for the small-size magazine receiving chamber 16S) is brought in contact with the outside of the inner door 22, and the pivoting for closing the outer door 20 itself is limited, failing in completely closing the door. In this case, since the safety switch dog 28 of the outer door 20 cannot be engaged with the safety switch 29, it is possible to make the control unit 9 display the event that the outer door 20 cannot be completely closed in the display section 19 and let the operator recognize the event. The operator, who has recognized the display, is able to recognize that the small size pallet 3S having abnormality in its support posture is included in the small-size magazine 4S, i.e., the inclusion of the small-size pallet 3S loaded in the reversely directed support posture and to take necessary measures. The recognition method (detection method) of the pallet 3 in the case where the reversely directed pallet 3 is included in the magazine 4 can be similarly carried out for the large-size magazine 4L.

Moreover, the plurality of large-size pallets 3L are loaded in the large-size magazine 4L as shown in Fig. 7A, where one large-size pallet 3L is put in a state in which the pallet is supported by rack sections 14 one of which is displaced by two steps without being supported by one pair of mutually opposed rack sections 14 by its side edge portions 3c. That is, the support side edge portions 3c are supported by the rack sections 14 that are not mutually opposed and put in a state in which the pallet is supported in an inclined support posture without maintaining the roughly horizontal support posture.

In the above case, if it is tried to close the inner door 22 of the large-size magazine 4L as shown in Fig. 10, then the end portion of the projection 26a of the combteeth guide section 26 provided inside the inner door 22 comes in contact and interferes with the rearward side edge portion 3b of the large-size pallet 3L in the inclined support posture (see Fig. 7A). Therefore, the pivotal position of the inner door 22 is limited (regulated) without inserting the projections 26a of the combteeth guide section 26 between the large-size pallets 3L, failing in completely closing the door. The pivoting of the outer door 20 (outer door 20 for the large-size magazine receiving chamber 16L) in the state in which the bumper section 25 is brought in contact with the outside of the inner door 22 is also limited (regulated), failing in completely closing the door. As a result, since the safety switch dog 28 of the outer door 20 cannot be engaged with the safety switch 29, it is possible to make the control unit. 9 display the event that the outer door 20 cannot be completely closed in the display section 19 to let the operator recognize the event. The operator, who has recognized the display, is able to recognize that the large-size pallet 3L loaded in the inclined support posture is included in the large-size magazine 4L and to take necessary measures. If the projection 26a of the combteeth guide section 26 is brought in contact with the large-size pallet 3L as described above, the projection 26a does not interfere directly with the large-size tray 2L and the electronic components 1 arranged on this large-size tray 2L since the position of contact is the edge portion of the large-size pallet 3L. The recognition method (detection method) of the pallet 3 in the case where the pallet 3 in the aforementioned inclined support posture is included in the magazine 4 can be similarly carried out for the small-size magazine 4S as shown in Fig. 10.

The state of the large-size magazine receiving chamber 16L shown in Fig. 9 shows a state in which a large-size pallet 4L having the reversely directed support posture and the inclined support posture is loaded in the large-size magazine 4L. In this state, the projection 26a of the combteeth guide section 26 is brought in contact with the forward side edge portion 3a of the large-size pallet 3L, and the insertion of the projections 26a is limited, so that the inner door 22 and the outer door 20 cannot be completely closed.

Moreover, the formation height of the projections 26a. and the arrangement of the combteeth guide section 26 in the horizontal direction in Figs. 7A and 7B are determined so that the projections 26a of the combteeth guide section 26 interfere with not only the large-size pallet 3L that has the inclined support posture and is supported by rack sections 14 displaced by two steps by its side edge portions 3c in the large-size magazine 4L as shown in Fig. 7A but also the large-size pallet 3L that has the inclined support posture and is supported by rack sections 14 displaced by one step. By thus forming and arranging the combteeth guide section 26, the inclined support postures displaced by one step, two steps or the like, which tends to be rather neglected by the operator, can reliably be detected.

It is to be noted that Figs. 8A and 8B show the state of the small-size magazine 4S corresponding to the large-size magazine 4L described with reference to Figs. 7A and 7B. Since similar contents as those of the description of Figs. 7A and 7B are possessed, no description is provided for the figures.

Moreover, when the abnormality of the support posture of the pallet 3 in the magazine 4 is detected by the limited closing of the outer door 20, it is possible to interlockingly stop the driving of the magazine elevation unit 8 by the control unit 9 and further stop the operation of the electronic component mounting apparatus 101 equipped with the electronic component feeder 100.

Although there has been described hereinabove the case where the plurality of projections 26a inserted between the pallets 3 are formed in the combteeth guide section 26 that regulates the roughly horizontal support posture of the pallets 3 and is able to detect the inclined support posture, the present embodiment is not limited only to the above-mentioned case. In place of the above-mentioned case, it is acceptable to form, for example, a plurality of rod-shaped or plate-shaped members so that the members are provided along the side surface on which the rack sections 14 are formed and are arranged between the pallets 3 in the magazine 4. In this case, there is an advantage that the loading itself of the pallet 3 in the inclined support posture can be prevented since the horizontal support posture of the pallet 3 is regulated when the pallet is loaded in the magazine 4.

Moreover, although one example of the configuration of the pallet 3 used for the electronic component feeder 100 is shown in Fig. 3, the configuration is not limited only to such the configuration. Any configuration can be used in place of that of Fig. 3 so long as the configuration is accepted in the magazine 4 and the regulated position (position in which the pallet 3 is brought in contact with the rearward guide section 24) by the rearward guide section 24 is different between the forwardly directed support posture and the reversely directed support posture in the state in which the support position on the forward side is regulated by the forward guide section 18.

Moreover, there has been described the case where the tray 2, on which the plurality of electronic components 1 are arranged in alignment, is placed on the upper surface of the pallet 3 as shown in Fig. 3. However, in place of this arrangement, it is acceptable to integrally form the tray 2 with the pallet 3 and load the tray 2 directly into the magazine 4 instead of the pallet 3.

By making it possible to easily identify the combination of a pair of rack sections 14 with a serial number or an identification color attached to the rack sections 14 of each magazine 4 so that a pair of rack sections 14 has an identical number or an identical color in place of or in addition to the method of preventing the insertion of the pallet 3 in the inclined support posture into the magazine 4 as described above, it is possible to attract the operator's attention in advance.

Moreover, it is also possible to provide the pallets 3 individually with a level and display a warning for attracting the operator's attention (by using, for example, a color display or the like) with the level when the pallet 3 is inserted in the inclined support posture into the magazine 4.

Moreover, it is also acceptable to use a method for flowing and a feeble current through the mutually paired rack sections 14 in a pair of rack sections 14 in the magazine 4 and detecting the current when the pallet 3 is inserted in the normal support posture.

According to the first embodiment, the following various effects can be obtained.

First of all, the electronic component feeder 100 has the forward guide section 18 that regulates the support position of each pallet 3 loaded in the magazine 4 by the rack sections 14 by being brought in contact with the edge portion of pallet 3 on the forward side in the pallet feed direction A and the rearward guide section 24 that is provided for the inner door 22 movably along the pallet feed direction A and regulates the pallet 3 regulated by the forward guide section 18 by being brought in contact with the edge portion of the pallet 3 on the rearward side in the pallet feed direction A. With this arrangement, when the pallet 3, which is provided with the grip portions 3d at the forward side edge portion 3a thereof and formed so as to have mutually different forward side and the rearward side edge configurations, is loaded in magazine 4, it can be detected that the pallet 3 loaded in the reversely directed support posture is included among the loaded pallets 3 on the basis of the difference in the regulation position (contact position) by the rearward guide section 24.

Furthermore, by providing the inner door 22 with the combteeth guide section 26, where a plurality of projections 26a to be inserted in the gaps between the pallets 3 loaded in the magazine 4 are formed, when all the projections 26a are inserted in the gaps, it can be detected that the pallets 3 are loaded with the roughly horizontal support posture maintained without being inclined. When any projection 26a comes in contact and interferes with the edge portion of any pallet 3, failing in inserting the projections 26a in the gaps, it can be detected that there is included a pallet 3 in the inclined support posture.

Moreover, the inner door 22 is provided with the rearward guide section 24 and the combteeth guide section 26. There is the arrangement that the inner door 22 can be closed in the position where the edge portion of the pallet 3 loaded in the forwardly directed support posture is brought in contact with the rearward guide section 24, the inner door 22 cannot be closed in the position where the edge portion of the pallet 3 loaded in the reversely directed support posture is brought in contact with the rearward guide section 24, and the inner door 22 cannot be closed even when the combteeth guide section 26 interferes with the pallet 3. With this arrangement, it can be detected whether or not there is abnormality in the support posture of each pallet 3 in the magazine 4, i.e., whether or not there is included a pallet 3 in the reversely directed support posture or the inclined support posture based on whether or not the inner door 22 can be closed.

Therefore, the abnormality of the support posture of each pallet 3 loaded in the magazine 4 can be reliably easily detected and the pallet 3 can be loaded consistently in the correct support posture in the electronic component feeder 100. Therefore, the operation stop of the electronic component mounting apparatus 101 attributed to the above-mentioned support postures of the pallets 3 and damages or the like of the constituent components of the electronic component feeder 100 can be prevented.

Moreover, the electronic component feeder 100 is provided with the outer door 20 that can be closed only when the inner door 22 is closed, the safety switch 29 and the safety switch dog 28 for detecting the opening/closing of this outer door 20 and further the display section 19 that can display this result of the opening/clos ing while allowing the operator to recognize the result, the operator is allowed to more reliably recognize the open/closed state of the inner door 22.

Moreover, with the inner door 22 provided for the magazine 4 and the outer door 20 provided for the main body section 5 as described above, the inner door 22 can be moved up and down integrally with the magazine 4, and the elevation operation of the magazine 4 is not hindered even when the combteeth guide section 26 is provided for the inner door 22.

Moreover, with the combteeth guide section 26 positioned not in the vicinity of the position intermediate between the mutually opposed rack sections 14 in the magazine 4 but closer to either one of the rack sections 14 away from the intermediate position, the projection 26a of the combteeth guide section 26 can more reliably come in contact and interfere with the pallet 3 in the inclined support posture.

Moreover, by virtue of the arrangement that the combteeth guide section 26 is arranged in position so as to interfere with the pallet 3 supported by the rack sections 14 displaced by two steps and the pallet 3 supported by the rack sections 14 displaced by one step and the arrangement that the dimensional relation between the formation height of each projection 26a and the gap between the pallets 3 is determined as described above, the inclined support postures displaced by one step and by two steps, which tend to be rather neglected by the operator, can reliably be detected.

Moreover, each projection 26a has the dimension of length so that the end of each projection 26a of the combteeth guide section 26 does not reach the region where the electronic components 1 are arranged in the tray 2 placed on the pallet 3 even when the inner door 22 is completely closed, the projection 26a is prevented from coming in contact with the electronic components 1 and from damaging the electronic components 1 in any case. Since comparatively expensive electronic components 1 such as IC chips are arranged on the tray 2 as described above, the capability of preventing the occurrence of damages of electronic components 1 as described above also reduces the manufacturing cost in component mounting and allows efficient component mounting to be achieved.

(Second Embodiment)

The present invention is not limited to the aforementioned embodiment but allowed to be put into practice in various other forms. For example, a tray plate structure capable of carrying out stable efficient electronic component feeding while preventing the leap-up or the like of the electronic component from the component feed tray by devising a method for fixing the component feed tray on the tray plate of one example of the pallet in the electronic component feeder 100 of the first embodiment or an electronic component feeder that has another construction will be described below as the second embodiment of the present invention.

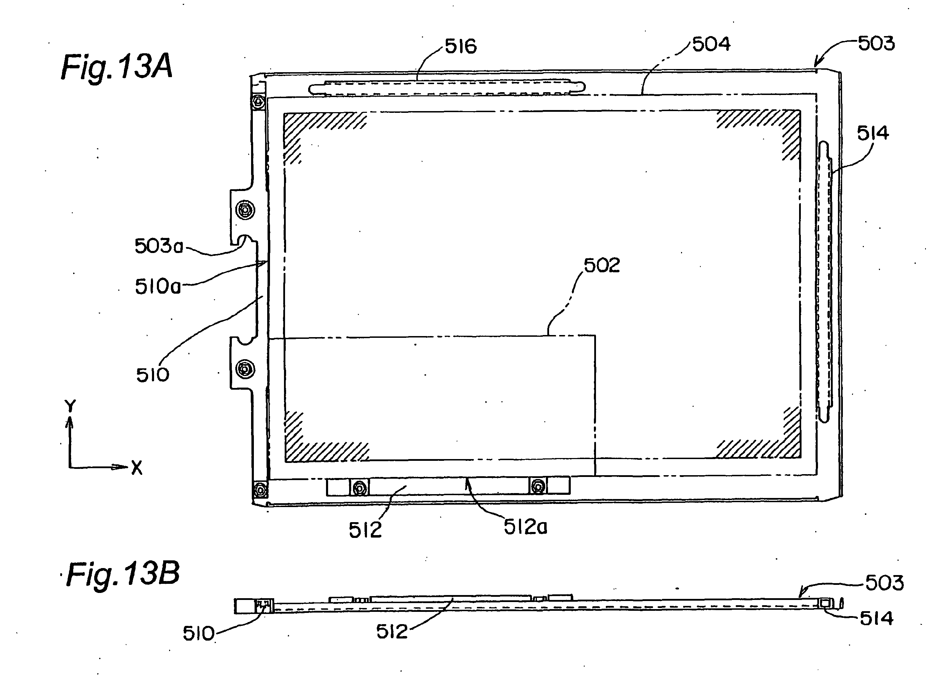

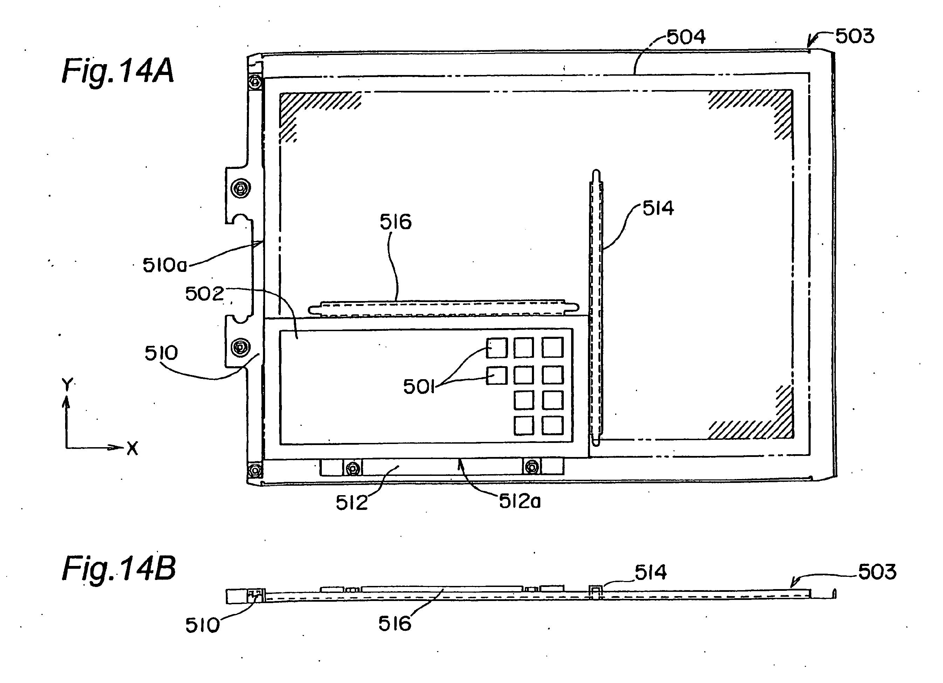

Fig. 13A shows a plan view of a tray plate 503 of one example of the placement section where the component feed tray handled in the electronic component feeder according to the present second embodiment is placed (also as one example of the pallet), and Fig. 13B shows its side view. Moreover, Fig. 14A shows a plan view in a state in which the component feed tray is placed on this tray plate 503, and Fig. 14b shows its side view.

As shown in Figs. 13A, 13B, 14A and 14B, the tray plate 503 has a roughly flat-plate-like rectangular shape and includes a placement surface (this may be a placement region) that receives a component feed tray 502 on which a plurality of electronic components 501 of one example of the electronic components are arranged while allowing the components to be picked up on its upper surface. This tray placement surface 504 is formed as a roughly quadrangular flat surface region formed within the upper surface of the tray plate 503 surrounded by the peripheral portions. A component feed tray 502 can be arranged so as to be positioned on this tray placement surface 504.

Such the tray plate 503 is used for feeding electronic components to a component mounting apparatus for mounting the electronic components on a circuit board. The plurality of the tray plates 503, each of which carries the component feed tray 502 placed thereon, are loaded in layers in a magazine or the like and unloaded from the magazine according to the type of the electronic components to be mounted on the circuit board. The desired electronic component is sucked and held and picked up from the component feed tray 502 placed on the unloaded tray plate 503 by a suction nozzle of one example of the component suction and holding member of the component mounting apparatus, and the electronic components can be mounted onto the circuit board by the component mounting apparatus.

The construction of this tray plate 503 will be described in detail as follows. As shown in Figs. 13A and 13B, an engagement portion 503a having a concave configuration is formed at the end portion, which is located on the left-hand side in the figure, of the tray plate 503. By engaging this engagement portion 503a with a pullout portion of a tray plate pullout unit (not shown), the tray plate 503 can be advanced and retreated in the illustrated X-axis direction. With this movable arrangement, for example, the tray plate 503 loaded in the magazine can be pulled out of the magazine or loaded into the magazine by the advancing and retreating movement.

Moreover, as shown in Figs. 13A and 13B, the component feed tray 502 is placed on the tray placement surface 504 of the tray plate 503 with the illustrated lower left corner portion served as a reference position. Therefore, the tray plate 503 is provided with an X-axis direction reference position regulating member 510 (hereinafter referred to as an X-axis reference member 510) of one example of the reference position regulating member for regulating the movement of the component feed tray 502 arranged in the reference position leftward in the illustrated X-axis direction and a Y-axis direction reference position regulating member 512 (hereinafter referred to as a Y-axis reference member 512) of one example of the reference position regulating member for regulating the movement downward in the illustrated Y-axis direction. This X-axis reference member 510 has an X-axis direction reference surface 510a (hereinafter referred to as an X-axis reference surface 510a), which is formed along the illustrated Y-axis direction and able to regulate the component feed tray 502 in the X-axis direction (i.e., lengthwise direction) by being brought in contact with the end portion of the component feed tray 502. The Y-axis reference member 512 has a Y-axis direction reference surface 512a (hereinafter referred to as a Y-axis reference surface 512a), which is formed along the illustrated X-axis direction and able to regulate the component feed tray 502 in the Y-axis direction (i.e., horizontal direction) by being brought in contact with the end portion of the component feed tray 502. In the present second embodiment, the X-axis direction and the Y-axis direction are the directions along the surface of the tray placement surface 504 and mutually perpendicular directions. Moreover, the X-axis reference member 510 and the Y-axis reference member 512 are fixed to the neighborhood of the respective edge portions of the tray plate 503 by, for example, being screwed or other means. In the present second embodiment, for example, the engagement portion 503a is formed integrally with the X-axis reference member 510 and formed on the surface opposite from the surface located on the side on which the X-axis reference surface 510a is formed at the X-axis reference member 510.

Moreover, as shown in Figs. 13A and 13B, the tray plate 503 is provided with an X-axis direction fixation bar 514 (hereinafter referred to as an X-axis fixation bar 514) of one example of the fixation bar that has a rod-shaped configuration and is able to regulate the rightward movement in the illustrated X-axis direction of the component feed tray 502 in the state in which its respective end portions are brought in contact with the X-axis reference surface 510a of the X-axis reference member 510 and the Y-axis reference surface 512a of the Y-axis reference member 512 and a Y-axis direction fixation bar 516 (hereinafter referred to as a Y-axis fixation bar 516) of one example of the fixation bar that has a rod-shaped configuration and is able to regulate the upward movement in the illustrated Y-axis direction of the component feed tray 502 in the above-mentioned state. The X-axis fixation bar 514 and the Y-axis fixation bar 516 have, for example, a mutually identical configuration and are able to magnetically releasably fix their arrangement positions in arbitrary positions on the tray placement surface 504 by means of built-in magnets.

Figs. 14A and 14B show a state in which the placement position of the component feed tray 502 placed on the tray placement surface 504 by means of the X-axis fixation bar 514 and the Y-axis fixation bar 516 as described above. As shown in Figs. 14A and 14B, with respect to the end portions of the component feed tray 502 in the state in which the movement thereof in the illustrated X-axis leftward direction and Y-axis downward direction are regulated by bringing the end portions in contact with the X-axis reference member 510 and the Y-axis reference member 512 on the tray placement surface 504 of the tray plate 503, the X-axis fixation bar 514 and the Y-axis fixation bar 516 are arranged on the tray placement surface 504 so as to be brought in contact with the end portions located on the sides opposite (i.e., the opposite sides) from the end portions. Further, by magnetically fixing the bars arranged, the rightward movement in the illustrated X-axis direction and the upward movement in the illustrated Y-axis direction of the component feed tray 502 can also be regulated. Therefore, the placement position of the component feed tray 502 on the tray placement surface 504 can be fixed in the illustrated X-axis direction and Y-axis direction, i.e., in the direction (i.e., the first direction) along the surface of the tray placement surfaces 504.

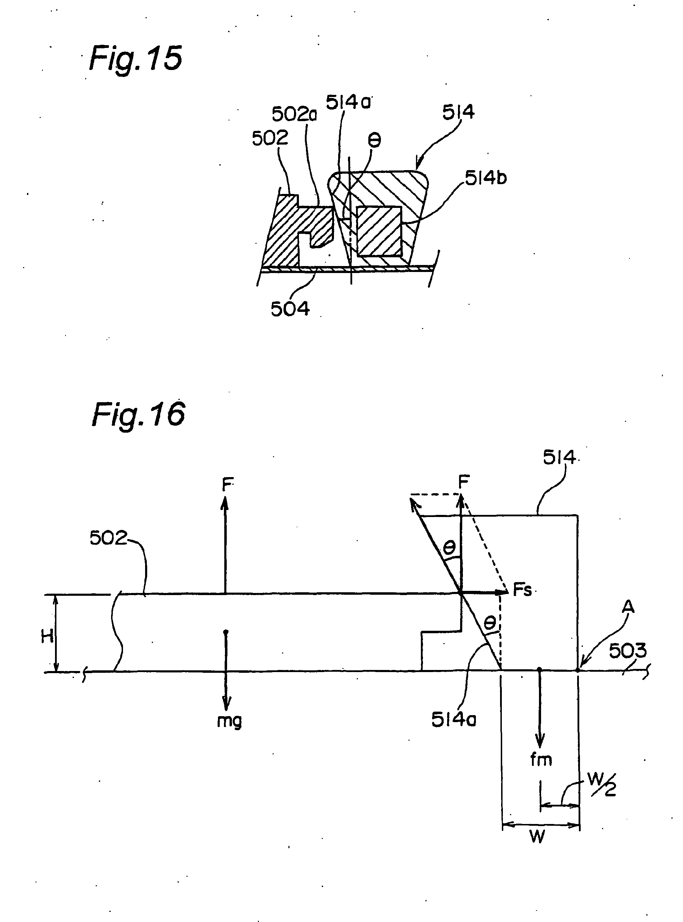

Fig. 15 shows a schematic sectional view showing the structure of the X-axis fixation bar 514 and the Y-axis fixation bar 516. In the present second embodiment, the X-axis fixation bar 514 and the Y-axis fixation bar 516 have a mutually identical structure, and therefore, Fig. 15 shows the cross section of the X-axis fixation bar 514 as a representative of them.

As shown in Fig. 15, the X-axis fixation bar 514 has a fixation surface 514a, which fixes the placement position of the component feed tray 502 in the X-axis direction by being brought in contact with the end portion 502a of the component feed tray 502. This fixation surface 514a is formed inclined at, for example, a prescribed angle θ with respect to a plane perpendicular to the tray placement surface 504. In other words, the surface is formed inclined at a prescribed angle (90° - θ°) without being perpendicular to the tray placement surface 504. This fixation surface 514a is formed so as to incline toward the component feed tray 502 side to be brought in contact vertically upwardly in Fig. 15. With the fixation surface 514a formed as described above, it becomes possible to regulate the movement in the horizontal direction in the figure (i.e., X-axis direction) of the component feed tray 502 brought in contact with this fixation surface 514a and to regulate also the movement in the vertical direction in the figure. Therefore, by employing the X-axis fixation bar 514 and the Y-axis fixation bar 516 that have the above-mentioned structure, it becomes possible to fix the component feed tray 502 in the illustrated X-axis direction and Y-axis direction on the tray placement surface 504 and to concurrently fix the tray in the direction perpendicular to the tray placement surface 504.

The inclined fixation surface 514a of the X-axis fixation bar 514 serves as one example for the fixation in the first direction that is the direction along the surface of the tray placement surface 504 (or one example of the first direction fixation portion) and also serves as one example for the fixation in a second direction that is the direction perpendicular to the surface of the tray placement surface 504 (or one example of the second direction fixation portion). That is, the fixation surface 514a concurrently serves as the first direction fixation surface and the second direction fixation surface formed as an identical surface.

Moreover, as shown in Fig. 15, such the fixation surface 514a is formed on the other side of the X-axis fixation bar 514. With the fixation surface 514a formed on both sides, the cross-sectional configuration of the X-axis fixation bar 514 can be made symmetrical, and either fixation surface 514a of the X-axis fixation bar 514 can be used. Therefore, the handlability can be made satisfactory.

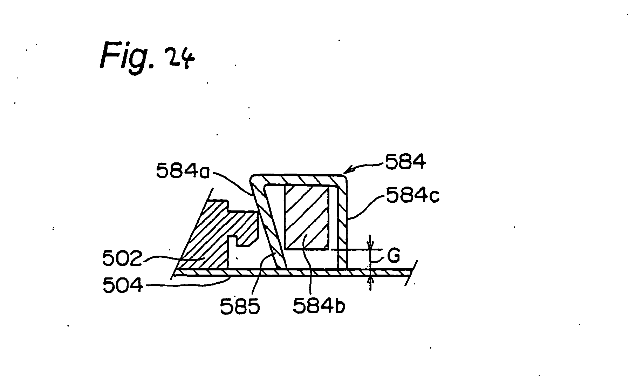

Moreover, instead of the case where the thus inclined fixation surfaces 514a are formed on both sides as described above, it is acceptable to form the inclined fixation surface 584a only on either one side as the X-axis fixation bar 584 shown in Fig. 24 and form a roughly perpendicular fixation surface 584c on the other side. In this case, the replacing work of the component feed tray 502 can be facilitated by fixing the component feed tray 502 by the roughly perpendicular fixation surface 584c. In this case, in order to assure reliable fixation, it is required that the warp of the component feed tray 502 is comparatively small, the weight of the component 501 accommodated in the component feed tray 502 is comparatively heavy, and the leap-up of the component 501 from the component feed tray 502 hardly occurs. Moreover, by fixing the component feed tray 502 by the inclined fixation surface 584a, the fixation of the component feed tray 502 can be made reliable. Particularly, when the warp of the component feed tray 502 is comparatively large, the strength is comparatively small and the weight of the component 501 accommodated in the component feed tray 502 is comparatively light, the fixation of the component feed tray 502 can be effectively achieved. That is, it becomes possible to select an optimum fixation method by selecting between the fixation surfaces according to the features of the component feed tray 502 of the object to be fixed. When the component feed tray 502 is fixed by the inclined fixation surface 584a, the fixed component feed tray 502 can be pressed against the tray placement surface 504 of the tray plate 503. Therefore, the component feed tray 502 and the tray plate 503 can be put in an integrated state, and the strength of the component feed tray 502 and the tray plate 503 can be improved. The tray plate 503 can be formed of a sheet metal having a thickness of, for example, about 0.5 mm.

Moreover, as shown in Fig. 15, a magnet section 514b, which is one example of the magnetic member formed of a magnetic material, is built in a lower portion of the X-axis fixation bar 514, so that the X-axis fixation bar 514 can be magnetically releasably fixed in the desired position on the tray placement surface 504. Moreover, as shown in Fig. 24, by providing a gap G between the lower surface of the magnet section 584b and the tray placement surface 504, there can be obtained a stronger magnetic field than in the state in which the lower surface of the magnet section 584b is brought in contact with the tray placement surface 504. It is to be noted that the member, which forms the fixation surfaces 584a and 584c of the X-axis fixation bar 584, is formed by bending, for example, an iron plate.

Here, Fig. 16 shows a schematic explanatory view showing forces generated in the X-axis fixation bar 514 and the Y-axis fixation bar 516 (note that the forces generated in the X-axis fixation bar 514 are typified) when erroneous suction is carried out by the suction nozzle on, for example, the component feed tray 502 in the state in which the placement position thereof is fixed and a suction force F is applied. In Fig. 16, it is assumed that the suction force applied to the component feed tray 502 by the suction nozzle is F, the dead weight of the component feed tray 502 is mg (g: gravitational acceleration), magnetic retentivity in the X-axis fixation bar 514 is fm, the inclination angle of the fixation surface 514a of the X-axis fixation bar 514 is θ, a horizontal component of force generated in the fixation surface 514a of the X-axis fixation bar 514 due to the suction force F is Fs, the width dimension of the lower surface of the X-axis fixation bar 514 is W, and the height (thickness) dimension of the component feed tray 502 is H.

First of all, in order to prevent the uplift of the component feed tray 502 from the tray plate 503 when the erroneous suction is carried out on the component feed tray 502 by the suction nozzle, it is required to satisfy the condition of the expression (1).

$$F < (mg + fm) \qquad \ldots (1)$$

Moreover, taking a moment generated around a point A at an end portion on the lower surface of the X-axis fixation bar 514 in Fig. 16 into consideration, it is required to satisfy the condition of the expression (2).

$$Fs \times H < fm \times W/2 \qquad \ldots (2)$$

The horizontal component of force Fs generated on the fixation surface 514a of the X-axis fixation bar 514 is expressed by the expression (3).

$$Fs = F \times \tan\theta \qquad \ldots (3)$$

Therefore, the inclination angle θ of the fixation surface 514a can be determined on the basis of the aforementioned conditions. The inclination angle θ can be determined within a range of, for example, about 1° to 30°.

Moreover, when the tray plate 503 on which the component feed tray 502 is placed is moved by being pulled out of the magazine, a horizontal force K based on the acceleration α due to the movement is to be generated in the component feed tray 502, and this horizontal force K is expressed by the expression (4).

$$K = mg \times \alpha \qquad \ldots (4)$$

Moreover, also in the state in which the horizontal force K is applied to the component feed tray 502, there is needed the condition of the expression (5) in order to reliably fix and hold the component feed tray 502 on the tray plate 503. It is to be noted that μ is the coefficient of friction between the lower surface of the X-axis fixation bar 514 and the tray plate 503.

$$K < fm \times \mu \qquad \ldots (5)$$

Moreover, taking the moment generated around the point A at the end portion on the lower surface of the X-axis fixation bar 514 in Fig. 16 into consideration, it is required to satisfy also the condition of the expression (6) .

$$K \times H < fm \times W/2 \qquad \ldots (6)$$

Therefore, the height (thickness) H of the component feed tray 502, the width dimension L of the lower surface of the X-axis fixation bar 514 and further the magnetic retentivity fm in the X-axis fixation bar 514 can be determined on the basis of the aforementioned conditions.

It is to be noted that the constructions of the X-axis fixation bar 514 and the Y-axis fixation bar 516, which are the fixation bars of the present second embodiment, are not limited to the aforementioned constructions but allowed to adopt other constructions. Several modification examples concerning the fixation bars will be described below.

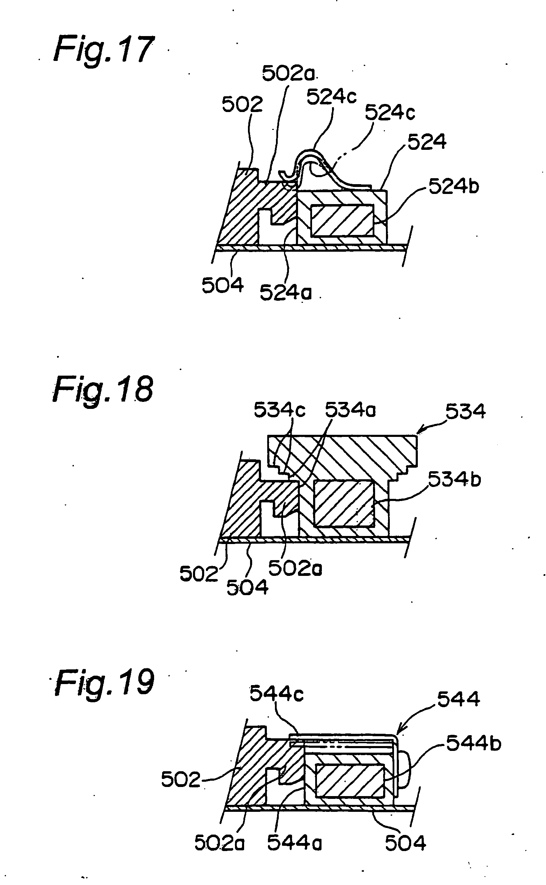

First of all, Fig. 17 shows a schematic sectional view of, for example, an X-axis fixation bar 524 of one example of the fixation bar according to a first modification example of the present second embodiment. As shown in Fig. 17, the X-axis fixation bar 524 is provided with a horizontal direction fixation surface 524a, which serves as one example of the first direction fixation portion and also as one example of the first direction fixation surface to fix the placement position of the component feed tray 502 in a direction along the surface of the tray placement surface 504 by being brought in contact with an end portion 502a of the component feed tray 502, and a vertical direction fixation spring (one example of the urging member) 524c, which serves as one example of a second direction fixation portion and also as a second direction fixation surface to fix the placement position of the component feed tray 502 in the direction perpendicular to the tray placement surface 504 by being brought in contact with an upper portion of the end portion 502a of the component feed tray 502 brought in contact with the horizontal direction fixation surface 524a and always urging the end portion 502a toward the tray placement surface 504.

Moreover, as shown in Fig. 17, the horizontal direction fixation surface 524a is formed so as to be roughly perpendicular to the tray placement surface 504 and able to come in surface contact with the end surface of the end portion 502a of the component feed tray 502 formed similarly roughly perpendicularly. Further, the vertical direction fixation spring 524c has one end fixed to an upper portion of the X-axis fixation bar 524 and is able to downwardly urge the end portion 502a with the other end brought in contact with the upper portion of the end portion 502a of the component feed tray 502.

It is to be noted that a magnet section 524b, which is one example of the magnetic material, is also built in the X-axis fixation bar 524 similarly to the X-axis fixation bar 514, so that the bar can be magnetically fixed in an arbitrary position on the tray placement surface 504.

By using the X-axis fixation bar 524 and the Y-axis fixation bar that has a similar structure, the placement position of the component feed tray 502 can be fixed in the horizontal direction and the vertical direction. Moreover, by forming the vertical direction fixation spring 524c. so that the urging force of the vertical direction fixation spring 524c becomes able to have a magnitude capable of resisting the suction force of the suction nozzle, it is possible to resist the suction force and prevent the uplift of the component feed tray 502 even when the component feed tray 502 is sucked and held by the erroneous suction of the suction nozzle. Although there has been described the case where the urging member is the vertical direction fixation spring 524c, it is also acceptable to employ an elastic member other than the spring in place of the above-mentioned case so long as the member can secure the urging function.

Next, a schematic sectional view of an X-axis fixation bar 534, which is one example of the fixation bar according to a second modification example of the present second embodiment, is shown in Fig. 18. As shown in Fig. 18, the X-axis fixation bar 534 is provided with a plurality of vertical direction fixation surfaces 534c, which serves as one example of a second direction fixation portion and as one example of a second direction fixation surface to fix the placement position of the component feed tray 502 in the direction perpendicular to the tray placement surface 504 by being brought in contact with the end portion 502a of the component feed tray 502. The vertical direction fixation surfaces 534c are formed at mutually different heights roughly parallel to the tray placement surface 504 and are able to come in contact with the end portion 502a of component feed trays 502 that have heights coinciding with the respective formation heights. Further, the X-axis fixation bar 534 is provided with a plurality of horizontal direction fixation surfaces 534a, which serve as one example of the first direction fixation portion and one example of the first direction fixation surface formed so as to individually correspond to the respective vertical direction fixation surfaces 534c and join the vertical direction fixation surfaces 534c that have mutually adjacent formation heights.

The horizontal direction fixation surfaces 534a are each formed so as to be roughly perpendicular to the tray placement surface 504 and able to fix the placement position of the component feed tray 502 to be brought in contact in the horizontal direction. As described above, the plurality of horizontal direction fixation surfaces 534a and the plurality of vertical direction fixation surfaces 534c are formed on the X-axis fixation bar 534, by which a plurality of step portions are formed of the mutually corresponding horizontal direction fixation surfaces 534a and vertical direction fixation surfaces 534c.

As shown in Fig. 18, the step portion confirming to the height of the end portion 502a of the component feed tray 502, i.e., the step portion confirming to the height position of contact with the end portion 502a is selected from among the plurality of step portions provided on the X-axis fixation bar 534, and the selected step portion is brought in contact with the end portion 502a. That is, the horizontal direction fixation surface 534a of the step portion is brought in contact with the end surface of the end portion 502a, while the vertical direction fixation surface 534c of the step portion is brought in contact with the upper surface of the end portion 502a. As a result, the placement position of the component feed tray 502 can be fixed in the horizontal direction and the vertical direction.

In forming the step portions, the step portions are required to be formed so that the areas of the horizontal direction fixation surfaces 534a and the vertical direction fixation surfaces 534c are able to achieve the fixation. For example, it is preferable to form the step portions so that the area of each vertical direction fixation surface 534c can resist the force that tries to uplift the component feed tray 502 caused by the erroneous suction of the suction nozzle.

Next, a schematic sectional view of an X-axis fixation bar 544, which is one example of the fixation bar according to a third modification example of the present second embodiment, is shown in Fig. 19. As shown in Fig. 19, the X-axis fixation bar 544 is provided with a horizontal direction fixation surface 544a, which serves as one example of the first direction fixation portion and as one example on the first direction fixation surface to fix the placement position of the component feed tray 502 in the direction along the tray placement surface 504 by being brought in contact with the end portion 502a of the component feed tray 502. Moreover, the X-axis fixation bar 544 is also provided with a vertical direction fixation portion 534c, which serves as one example of the second direction fixation portion and as one example on the second direction fixation surface to fix the placement position of the component feed tray 502 in the direction perpendicular to the tray placement surface 504.

As shown in Fig. 19, the vertical direction fixation portion 534c can be adjusted so as to vary the fixation height position thereof. Therefore, the height position of the vertical direction fixation portion 534c can be adjusted in accordance with the height of the end portion 502a of the component feed tray 502 of which the placement position is fixed, and various types of component feed trays 502 can be fixed.

Moreover, in the present second embodiment, there has been described the case where both the X-axis fixation bars 514 and the Y-axis fixation bars 516 have the built-in magnet sections and are able to be magnetically fixed on the tray placement surface 504. However, the present second embodiment is not limited to the above case but allowed to adopt fixation means of other fixation bars.

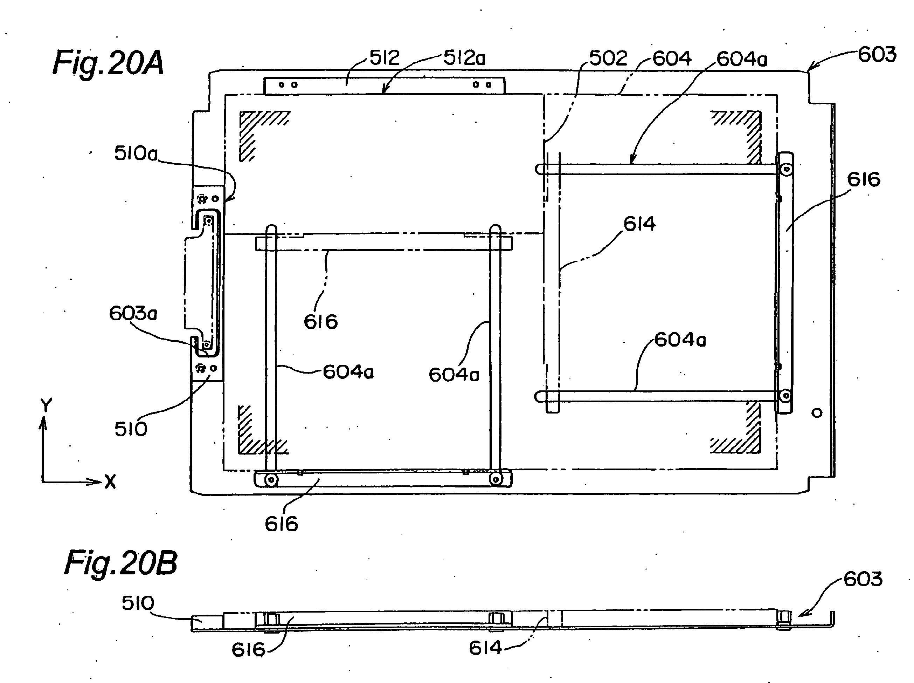

For example, as shown in the schematic plan view and the side view of the tray plate 603 of Figs. 20A and 20B, it is acceptable to provide a plurality of slot portions 604a on the tray placement surface 604 of the tray plate 603 and allow fixation bars 614 and 616 to be releasably fixed by means of screws or the like in arbitrary positions within the formation range of each of the slot portions 604a.

The above fixation means are effective means in that magnetic influence on the electronic components 501 can be prevented by the nonuse of magnetic fixation means when, for example, electronic components 501 that are apt to be easily damaged by magnetic influence, are arranged and accommodated in the component feed tray 502.

Moreover, there is a further advantage that, even when the force that tries to uplift the component feed tray 502 when the suction force of the suction nozzle is great and the component feed tray 502 is erroneously sucked by the suction nozzle becomes greater than the magnetic force of the magnet section 514b or the like, the mechanical force of the engagement of screws or the like with the slot portions 604a can resist the uplifting force, and the uplift of the component feed tray 502 can reliably be prevented.

According to the second embodiment, the following various effects can be obtained.

First of all, the X-axis fixation bar 514 and the Y-axis fixation bar 516 are provided with not only the function to fix the placement position of the component feed tray 502 placed on the tray placement surface 504 of the tray plate 503 in the direction (horizontal direction) along the surface of the tray placement surface 504 but also the function to concurrently fix the placement position in the direction (vertical direction) perpendicular to the tray placement surface 504. With this arrangement, the component feed tray 502 can be fixed in the horizontal direction and the vertical direction. Therefore, even when the component feed tray 502 is erroneously sucked by the suction nozzle, the occurrence of the uplift of the component feed tray 502 can be prevented beforehand by virtue of the fixation also in the vertical direction. Therefore, the leap-up and the occurrence of displacement of the electronic components 501 possibly occurring in accordance with the uplift of component feed tray 502 can be prevented beforehand, and efficient component mounting can be achieved.

In concrete, for example, the X-axis fixation bar 514 (likewise in the case of the Y-axis fixation bar) is provided with the fixation surface 514a that has a surface inclined with respect to the plane perpendicular to the tray placement surface 504. With this arrangement, the placement position of the component feed tray 502, which is brought in contact with this fixation surface 514a, can be concurrently fixed not only in the horizontal direction but also in the vertical direction. That is, the concurrent fixation can be achieved by the fixation surface 514a that is one inclined surface.

Moreover, by virtue of the fact that the fixation surface 514a is the inclined surface, there can be provided a fixation bar, which can cope with the fixation of component feed trays 502 provided with the end portions 502a having various configurations and has versatility.

Moreover, in the case where the inclination angle θ of the fixation surface 514a of the X-axis fixation bar 514 is gently inclined with respect to, for example, the plane perpendicular to the tray placement surface 504, the fixation bar can cope with the fixation of the component feed trays 502 of more various end configurations. Conversely, in the case where the surface is largely inclined with respect to the perpendicular plane, the fixation in the vertical direction can more reliably be achieved. As described above, in the case where the surface is largely inclined, the bar can be very effective for the fixation of a component feed tray 502 reduced in thickness. Therefore, by utilizing such a feature, an appropriate inclination angle θ can be set according to the configuration of the component feed tray 502, the fixation force and so on.

Moreover, when the X-axis fixation bars 524, 534 or 544 is provided with the vertical direction fixation spring 524c or provided with the plurality of step portions formed of the plurality of horizontal direction fixation surfaces 534a and the plurality of vertical direction fixation surfaces 534c or provided with the vertical direction fixation surface 544c of which the formation height is variable and adjustable, the bar can cope with the fixation of the component feed tray 502 that has various end configurations.

Moreover, by fixing the end portion 502a of the component feed tray 502 in the vertical direction by the X-axis fixation bar 514 or the like even when the component feed tray 502 is deformed and warped, the tray can be placed on the tray placement surface 504 in a state in which the warp is corrected. Therefore, even in this case, it becomes possible to achieve stable pickup of the electronic component 501 by the suction nozzle.

Moreover, by making the X-axis reference surface 510a of the X-axis reference member 510 and the Y-axis reference surface 512a of the Y-axis reference member 512 shown in Figs. 13A and 13B serve as inclined surfaces, the prevention of the uplift of the component feed tray 502 can be further assured.

It is to be noted that the effects possessed by the aforementioned various embodiments can be produced by properly combining arbitrary ones of the embodiments.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

**Claims**

1. An electronic component feeder (100) for loading a plurality of pallets (3, 3L, 3S) on each of which a component feed tray (2, 2L, 2S) for carrying a plurality of electronic components (1) arranged in alignment are placed in a plurality of stacked tiers, for feeding the electronic components on the component feed tray placed on a pallet unloaded from among the loaded pallets to an electronic component feed position (107) along a pallet feed direction (A), the feeder comprising:

   a magazine (4, 4L, 4S) includes a plurality of pairs of support sections (14) which are formed at regular intervals in a stacking direction, for supporting mutually opposed edge portions (3c) of the pallets in a direction perpendicular to the pallet feed direction so that the pallets are supported roughly horizontally and movably in the pallet feed direction and a magazine door section (22) which is an openable door provided on a rearward side in the pallet feed direction for feeding and loading the pallets from the rearward side, for loading the pallets supported by the corresponding pairs of support sections;
   a magazine receiver (5) for receiving the magazine elevatably, which has a pallet feed port (6) for allowing the pallets loaded in the magazine to be unloaded from inside the magazine to an electronic component feed position;
   a magazine elevation unit (8) for driving elevation of the magazine inside the magazine receiver while allowing a selected pallet to be unloaded through the pallet feed port;
   a forward-side regulating member (18) for regulating support positions of the pallets loaded in the magazine by the corresponding support sections by being brought in contact with an edge portion of the pallet on a forward side in the pallet feed direction;
   a rearward-side regulating member (24), which is fixed on an inside of the magazine door section and movable in the pallet feed direction with the magazine door section, for regulating support positions of the pallets regulated by the forward-side regulating member by the corresponding support sections by being brought in contact with an edge portion of the pallet on the rearward side in the pallet feed direction; and

a horizontal posture regulating member (26), which is fixed on the inside of the magazine door section, for regulating the roughly horizontal support posture of the pallets so that the support posture of each of the pallets, whose edge portions are supported by the corresponding pairs of support sections, by being arranged between the pallets stacked in tiers in the magazine,

wherein the pallets being formed so that configurations of a forward-side edge portion and a rearward-side edge portion in the pallet feed direction are formed differently,

the rearward-side regulating member allows to limit closing of the magazine door section by bringing in contact with the edge portion of the pallet supported in a reversely directed support posture in the pallet feed direction, and allows to close the magazine door section in a position where the rearward-side regulating member is brought in contact with the edge portion of the pallet supported in a forwardly directed support posture in the pallet feed direction in the magazine,

the horizontal posture regulating member allows to limit closing of the magazine door section by bringing in contact with the edge portion of the pallet supported by the support sections that are not mutually opposed, and allows to close the magazine door section by inserting between the pallets supported by the pair of support sections in the magazine, and

inclusion of the pallet that has abnormality in its support posture in the magazine can be detected by the limitation of the closing of the magazine door section.

2. The electronic component feeder as claimed in claim 1, further comprising:

a door opening/closing detector (28, 29) for detecting the open state or the closed state of the magazine door section; and

a door opening and closing display section (19) for displaying a detection result by the door opening/closing detector while allowing an operator to recognize the result.

3. The electronic component feeder as claimed in claim 2, wherein the magazine receiver has a receiver door section (20) that is an openable door provided on the rearward side in the pallet feed direction, for being closed in a state in which its inside (25) is brought in contact with outside of the magazine door section in the closed state, for being limited its closing by bringing in contact with the outside of the magazine door section to limit the closing.

4. The electronic component feeder as claimed in claim 3, wherein the door opening/closing detector (28) is provided for the receiver door section.

5. The electronic component feeder as claimed in claim 2, further comprising a control unit (9) for stopping driving operation of the magazine elevation unit when the open state of the magazine door section is detected by the door opening/closing detector.

6. The electronic component feeder as claimed in claim 1, wherein the horizontal posture regulating member is provided with a plurality of projections (26a) which are formed arranged in the stacking direction at the same intervals as the intervals of the support sections, for being inserted in gaps between the pallets supported by the pair of support sections, for being limited to insert in the gaps by bringing in contact with the edge portion of the pallets supported by the support sections that are not mutually opposed.

7. The electronic component feeder as claimed in claim 6, wherein the horizontal posture regulating member is fixed on the magazine door section so that the projections are arranged in positions located closer to either one of the support sections away from a possible intermediate between the mutually opposed support sections in a state in which the magazine door section is closed.

8. The electronic component feeder as claimed in claim 7, wherein the projections are arranged so that any of the projections interferes with the pallet supported by the support sections which include the other support section displaced by at least one step in the stacking direction with respect to the support section opposed to one support section.

9. The electronic component feeder as claimed in claim 1, wherein each of the pallets has a pallet unloading grip portion (3d), which has a roughly rectangular shape and is formed roughly in a protruding configuration at an edge portion (3a) located on the forward side in the pallet feed direction, and

the rearward-side regulating member is arranged so as to be able to come in contact with the grip portion of the pallet supported in the reversely directed support posture by the support sections.

10. The electronic component feeder as claimed in claim 6, wherein the projections of the horizontal posture regulating member have a length dimension such that the projections do not reach a place above an arrangement region of the electronic components on the component feed tray placed on each of the pallets in a state in which the projections are inserted in gaps between the pallets.

11. The electronic component feeder as claimed in claim 1, wherein
the feeder further comprises a component feed tray fixation bar (514, 516, 524, 534, 544, 614, 616) for fixing the component feed tray releasably on a placement surface (504, 604) of the pallet, and
the fixation bar comprising:

a first direction fixation portion (514a, 524a, 534a, 544a), for releasably fixing its arrangement position on the placement surface, for releasably fixing the placement position of the component feed tray in a first direction (X- or Y-direction) that is a direction along the placement surface by being brought in contact with the component feed tray placed on the placement surface;
a second direction fixation portion (514a, 524c, 534c, 544c), for releasably fixing its arrangement position on the placement surface, for releasably fixing the placement position in a second direction that is a direction roughly perpendicular to the placement surface by being brought in contact with the component feed tray; and
a magnetic member formed of a magnetic material on or near its arrangement surface on the placement surface, for being fixed on the placement surface by a magnetic force of the magnetic member.

12. The electronic component feeder as claimed in claim 11, wherein, with regard to the component feed tray fixation bar, the first direction fixation portion is the first direction fixation surface (534a, 544a) formed roughly perpendicular to the placement position where the placement position is fixed in the first direction by being brought in contact with an end portion (502a) of the component feed tray, and
the second direction fixation portion is the second direction fixation surface (534c, 544c) formed roughly perpendicular to the placement position where the placement position is fixed in the second direction by being brought in contact with an end portion of the component feed tray.

13. The electronic component feeder as claimed in claim 12, wherein, with regard to the component feed tray fixation bar, a height position of the second direction fixation surface (544c) brought in contact with the edge portion of the component feed tray is adjustable in the second direction.

14. The electronic component feeder as claimed in claim 11, wherein, with regard to the component feed tray fixation bar, the fixation bar (524) is provided with an urging member (524c) that always urges the second direction fixation portion toward the end portion of the component feed tray.

15. The electronic component feeder as claimed in claim 12, wherein, with regard to the component feed tray fixation bar, the fixation bar (534) comprising:

a plurality of the second direction fixation surfaces (534c) formed at different height levels; and
a plurality of the first direction fixation surfaces (534a) individually corresponding to the second direction fixation surfaces, and
the placement position of the component feed tray is fixed by the second direction fixation surface that conforms to the height of the end portion of the component feed tray and belongs to the second direction fixation surfaces and the first direction fixation surface that corresponds to the second direction fixation surface.

16. The electronic component feeder as claimed in claim 11, wherein, with regard to the component feed tray fixation bar, the first direction fixation portion is the first direction fixation surface for fixing the placement position in the first direction by being brought in contact with the end portion of the component feed tray,
the second direction fixation portion is the second direction fixation surface for fixing the placement position in the second direction by being brought in contact with the end portion of the component feed tray, and
the first direction fixation surface and the second direction fixation surface serve as an identical fixation surface (514a) formed inclined with respect to the placement surface.

17. An electronic component feeding method using a feeder (100) for loading a plurality of pallets (3, 3L, 3S) on each of which a component feed tray (2, 2L, 2S) for carrying a plurality of electronic components (1) arranged in alignment are placed in a plurality of stacked tiers, for feeding the electronic components on the component feed tray placed on a pallet unloaded from among the loaded pallets to an electronic component feed position (107) along a pallet feed direction (A), wherein the feeder comprises

a magazine (4, 4L, 4S) which includes a plurality of pairs of support sections (14) which are formed at regular intervals in a stacking direction, for supporting mutually opposed edge portions (3c) of the pallets in a direction perpendicular to the pallet feed direction so that the pallets are supported roughly horizontally and movably in the pallet feed direction and a magazine door section (22) which is an openable door provided on a rearward side in the pallet feed direction for feeding and loading the pallets from the rearward side, for loading the pallets supported by the corresponding pairs of support sections, the method comprising the steps of :

receiving by a magazine receiver (5), the magazine elevatably, which has a pallet feed port (6) for allowing the pallets loaded in the magazine to be unloaded from inside the magazine to an electronic component feed position; driving by a magazine elevation unit (8), elevation of the magazine inside the magazine receiver while allowing a selected pallet to be unloaded through the pallet feed port;
regulating, by a forward-side regulating member (18), support positions of the pallets loaded in the magazine by the corresponding support sections by being brought in contact with an edge portion of the pallet on a forward side in the pallet feed direction;
regulating, by a rearward-side regulating member (24), which is fixed on an inside of the magazine door section and movable in the pallet feed direction with the magazine door section, support positions of the pallets regulated by the forward-side regulating member by the corresponding support sections by being brought in contact with an edge portion of the pallet on the rearward side in the pallet feed direction; and
regulating, by a horizontal posture regulating member (26), which is fixed on the inside of the magazine door section, the roughly horizontal support posture of the pallets so that the support posture of each of the pallets, whose edge portions are supported by the corresponding pairs of support sections, by being arranged between the pallets stacked in tiers in the magazine,

wherein the pallets being formed so that configurations of a forward-side edge portion and a rearward-side edge portion in the pallet feed direction are formed differently,
the rearward-side regulating member allows to limit closing of the magazine door section by bringing in contact with the edge portion of the pallet supported in a reversely directed support posture in the pallet feed direction, and allows to close the magazine door section in a position where the rearward-side regulating member is brought in contact with the edge portion of the pallet supported in a forwardly directed support posture in the pallet feed direction in the magazine,
the horizontal posture regulating member allows to limit closing of the magazine door section by bringing in contact with the edge portion of the pallet supported by the support sections that are not mutually opposed, and allows to close the magazine door section by inserting between the pallets supported by the pair of support sections in the magazine, and
inclusion of the pallet that has abnormality in its support posture in the magazine can be detected by the limitation of the closing of the magazine door section.


**Patentansprüche**

1. Zuführeinrichtung (100) für elektronische Bauelemente zum Laden einer Mehrzahl von Paletten (3, 3L, 3S), auf denen je ein Bauelementezuführträger (2, 2L, 2S) zum Tragen einer Mehrzahl von ausgerichteten elektronischen Bauelementen (1) in einer Mehrzahl von gestapelten Schichten angeordnet ist, zum Zuführen der elektronischen Bauelemente auf dem Bauelementezuführträger, der auf einer Palette, die aus den beladenen Paletten heraus an eine Zuführposition (107) für elektronische Bauelemente entlang einer Palettenzuführrichtung (A) geführt wird, wobei die Zuführeinrichtung folgendes enthält:

ein Magazin (4, 4L, 4S), das eine Mehrzahl von Paaren von Trägersektionen (14) enthält, die in regelmäßigen Abständen in einer Stapelrichtung gebildet sind zum Unterstützen von einander gegenüberliegenden Kantenteilen (3c) der Paletten in einer Richtung rechtwinklig zur der Palettenzuführrichtung, so dass die Paletten etwa horizontal und in der Palettenzuführrichtung beweglich unterstützt werden, und das eine Magazintürsektion (22) enthält, die eine zu öffnende Tür an einer Rückseite in Palettenzuführrichtung zum Zuführen und Laden der Paletten von der Rückseite darstellt zum Laden der durch die entsprechenden Paare von Trägersektionen getragenen Paletten;

eine Magazinaufnahme (5) zur anhebbaren Aufnahme des Magazins, die einen Palettenzuführport (6) aufweist, damit die in das Magazin geladenen Paletten von der Innenseite des Magazins an eine Zuführposition für elektronische Bauelemente entladen werden können;

eine Magazinanhebeeinheit (8) zum Anheben des Magazins innerhalb der Magazinaufnahme, wobei eine ausgewählte Palette durch den Palettenzuführport entladen werden kann;

ein Regulierglied (18) auf der Vorderseite zum Regulieren der Tragpositionen der in das Magazin geladenen Paletten durch entsprechende Tragsektionen durch Inkontaktbringen mit einem Kantenabschnitt der Palette auf der, in der Palettenzuführrichtung vorderen Seite,

ein Regulierglied (24) auf der Rückseite, das auf einer Innenseite der Magazintürsektion befestigt und in der Palettenzuführrichtung mit der Magazintürsektion bewegbar ist zum Regulieren der Tragpositionen der Paletten, die durch das Regulierglied auf der Vorderseite durch die entsprechenden Tragsektionen durch Inkontaktbringen mit einem Kantenabschnitt der Palette auf der, in der Palettenzuführrichtung rückwärtigen Seite reguliert werden; und

ein Regulierglied (26) für die horizontale Position, das auf einer Innenseite der Magazintürsektion befestigt ist zum Regulieren der etwa horizontalen Tragposition der Paletten in der Art, dass die Tragposition jeder der Paletten, deren Kantenabschnitte durch die entsprechenden Paare von Tragsektionen getragen werden, zwischen den in Schichten in dem Magazin gestapelten Paletten angeordnet ist,

wobei die Paletten so geformt sind, dass Konfigurationen eines Kantenabschnitts auf der Vorderseite und eines Kantenabschnitts auf der Rückseite in der Palettenzuführrichtung unterschiedlich geformt sind,

wobei das Regulierglied auf der Rückseite es ermöglicht, das Schließen der Magazintürsektion zu begrenzen durch Inkontaktbringen mit dem Kantenabschnitt der Palette, der in einer umgekehrt gerichteten Tragposition in der Palettenzuführrichtung getragen wird, und es erlaubt, die Magazintürsektion in einer Position zu schließen, in der das Regulierglied auf der Rückseite in Kontakt mit dem Kantenabschnitt der Palette gebracht wird, die in einer in der Palettenzuführrichtung vorwärts gerichteten Tragposition in dem Magazin getragen wird,

wobei das Regulierglied für die horizontale Position es ermöglicht, das Schließen der Magazintürsektion zu begrenzen durch Inkontaktbringen mit dem Kantenabschnitt der Palette, der durch die nicht einander gegenüber liegenden Tragsektionen getragen wird, und es erlaubt, die Magazintürsektion durch Einfügen zwischen die Paletten, die durch das Paar von Tragsektionen in dem Magazin getragen werden, zu schließen, und

wobei das Einfügen der Palette, die eine Abnormalität in ihrer Tragposition in dem Magazin aufweist, durch die Einschränkung beim Schließen der Magazintürsektion festgestellt werden kann.

2. Zuführeinrichtung für elektronische Bauelemente nach Anspruch 1, weiter **gekennzeichnet durch**
einen Türdetektor (28, 29) zum Feststellen des geöffneten Zustands oder des geschlossenen Zustands der Magazintürsektion, und
einen Anzeigeabschnitt (19) zum Anzeigen des Türdetektorergebnisses, damit eine Bedienungsperson dieses Ergebnis erkennen kann.

3. Zuführeinrichtung für elektronische Bauelemente nach Anspruch 2, **dadurch gekennzeichnet, dass** die Magazinaufnahme eine Magazintürsektion (20) aufweist, die eine zu öffnende Tür in Palettenzuführrichtung an der Rückseite aufweist zum Schließen in einem Zustand, in dem ihre Innenseite (25) im geschlossenen Zustand in Kontakt mit der Außenseite der Magazintürsektion gebracht wird, um beim Schließen begrenzt zu werden durch Inkontaktbringen mit der Außenseite der Magazintürsektion zum Begrenzen des Schließens.

4. Zuführeinrichtung für elektronische Bauelemente nach Anspruch 3, **dadurch gekennzeichnet, dass** der Türdetektor (28, 29) zum Öffnen/Schließen für die Aufnahmetürsektion vorgesehen ist.

5. Zuführeinrichtung für elektronische Bauelemente nach Anspruch 2, weiter **gekennzeichnet durch** eine Steuereinheit (9) zum Anhalten des Antriebsvorgangs der Magazinanhebungseinheit, wenn der offene Zustand der Magazintürsektion durch den Türdetektor erkannt wird.

6. Zuführeinrichtung für elektronische Bauelemente nach Anspruch 1, **dadurch gekennzeichnet, dass** das Regulierglied für die horizontale Position mit einer Mehrzahl von Vorsprüngen (26a) versehen ist, die in der Stapelrichtung in gleichen Abständen wie die Abstände der Tragsektionen angeordnet sind, um in die Zwischenräume zwischen den durch das Paar von Tragsektionen getragenen Paletten eingesetzt zu werden, um das Einsetzen in die Zwischenräume zu begrenzen durch Inkontaktbringen mit dem Kantenabschnitt der Paletten, die durch die nicht einander gegenüberliegenden Tragsektionen getragen werden.

7. Zuführeinrichtung für elektronische Bauelemente nach Anspruch 6, **dadurch gekennzeichnet, dass** das Regulierglied für die horizontale Position an der Magazintürsektion derart befestigt ist, dass die Vorsprünge in Positionen angeordnet sind, die näher an dem einen oder dem anderen der Tragsektionen angeordnet sind, die entfernt von einer möglichen Mitte zwischen den einander gegenüber liegenden Tragsektionen in einem Zustand liegen, in dem die Magazintürsektion geschlossen ist.

8. Zuführeinrichtung für elektronische Bauelemente nach Anspruch 7, **dadurch gekennzeichnet, dass** die Vorsprünge derart angeordnet sind, dass irgendeiner der Vorsprünge mit der Palette kollidiert, die durch die Tragsektionen getragen werden, die die andere Tragsektion einschließen, die um durch mindestens einen Schritt in der Stapelrichtung gegenüber der Tragsektion versetzt ist, der der einen Tragsektion gegenüber liegt.

9. Zuführeinrichtung für elektronische Bauelemente nach Anspruch 1, **dadurch gekennzeichnet,**
**dass** jede der Paletten einen Palettenentladegreifabschnitt (3d) aufweist, der eine etwa rechteckige Form hat und in etwa in einer vorstehenden Konfiguration an einem Kantenabschnitt (3a) ausgebildet ist, der an der Vorderseite in der Palettenzuführrichtung angeordnet ist, und
**dass** das Regulierglied an der Rückseite so angeordnet ist, dass es in der Lage ist, in Kontakt mit dem Greifabschnitt der Palette zu kommen, die in der rückwärts gerichteten Tragposition durch die Tragsektion getragen wird.

10. Zuführeinrichtung für elektronische Bauelemente nach Anspruch 6, **dadurch gekennzeichnet, dass** die Vorsprünge des Regulierungsgliedes für die horizontale Position eine derartige Längenausdehnung haben, dass die Vorsprünge nicht einen Platz oberhalb eines Anordnungsbereiches der elektronischen Bauelemente auf dem Bauelementezuführträger erreichen, der auf jeder der Paletten in einem Zustand platziert ist, in dem die Vorsprünge in Zwischenräume zwischen den Paletten eingesetzt sind.

11. Zuführeinrichtung für elektronische Bauelemente nach Anspruch 1, **dadurch gekennzeichnet,**
**dass** die Zuführeinrichtung darüber hinaus eine Bauelemente-Zuführträger-Fixierstange (514, 516, 524, 534, 544, 614, 616) aufweist zum lösbaren Fixieren des Bauelemente-Zuführträgers auf einer Ablagefläche (504, 604) der Palette, und
**dass** die Fixierstange Folgendes enthält:

einen ersten Fixierabschnitt (514a, 524a, 534a, 544a) für eine erste Richtung zum lösbaren Fixieren seiner Anordnungsposition auf der Anordnungsoberfläche, zum lösbaren Fixieren der Ablageposition des Bauelemente-Zuführträgers in einer ersten Richtung (X- oder Y-Richtung), die eine Richtung entlang der Ablagefläche ist, durch Inkontaktbringen mit dem auf der Ablagefläche platzierten Bauelemente-Zuführträger;
einen zweiten Fixierabschnitt (514c, 524c, 534c, 544c) für eine zweite Richtung zum lösbaren Fixieren seiner Anordnungsposition auf der Anordnungsoberfläche, zum lösbaren Fixieren der Ablageposition des Bauelemente-Zuführträgers in einer zweiten Richtung, die eine Richtung etwa rechtwinklig zu der Ablagefläche ist, durch Inkontaktbringen mit dem Bauelemente-Zuführträgers; und
ein magnetisches Glied aus Magnetmaterial auf oder in der Nähe seiner Anordnungsfläche auf der Ablagefläche zum Fixieren auf der Ablagefläche durch eine Magnetkraft des magnetischen Gliedes.

12. Zuführeinrichtung für elektronische Bauelemente nach Anspruch 11, **dadurch gekennzeichnet, dass** in Bezug auf die Bauelemente-Zuführträger-Fixierstange
der erste Fixierabschnitt für die erste Richtung die erste Fixierfläche (534a, 544a) für die erste Richtung ist, die etwa rechtwinklig zu der Ablageposition gebildet ist, an der die Ablageposition in der ersten Richtung fixiert ist durch Inkontaktbringen mit einem Endabschnitt (502a) des Bauelemente-Zuführträgers, und
der zweite Fixierabschnitt für die zweite Richtung die zweite Fixierfläche (534c, 544c) für die zweite Richtung ist, die etwa rechtwinklig zu der Ablageposition gebildet ist, an der die Ablageposition in der zweiten Richtung fixiert ist durch Inkontaktbringen mit einem Endabschnitt des Bauelemente-Zuführträgers.

13. Zuführeinrichtung für elektronische Bauelemente nach Anspruch 12, **dadurch gekennzeichnet, dass** in Bezug auf die Bauelemente-Zuführträger-Fixierstange
eine Höhenposition der zweiten Fixierfläche (544c) für die zweite Richtung, die in Kontakt mit dem Kantenabschnitt des Bauelemente-Zuführträgers gebracht wird, in der zweiten Richtung justierbar ist.

14. Zuführeinrichtung für elektronische Bauelemente nach Anspruch 11, **dadurch gekennzeichnet, dass** in Bezug auf die Bauelemente-Zuführträger-Fixierstange
die Fixierstange (524) mit einem Vorspannglied (524c) versehen ist, das den Fixierabschnitt für die zweite Richtung immer in Richtung des Endabschnittes des Bauelemente-Zuführträgers vorspannt.

**15.** Zuführeinrichtung für elektronische Bauelemente nach Anspruch 12, **dadurch gekennzeichnet, dass** in Bezug auf die Bauelemente-Zuführträger-Fixierstange
die Fixierstange (534) Folgendes enthält:

eine Mehrzahl von Fixierflächen (534c) für die zweite Richtung, die in verschiedenen Höhen ausgebildet sind, eine Mehrzahl der Fixierflächen (534a) für die erste Richtung, die den Fixierflächen für die zweite Richtung einzeln zugeordnet sind, und
dass die Ablageposition des Bauelemente-Zuführträgers durch die Fixierfläche für die zweite Richtung fixiert ist, die der Höhe der des Endabschnittes des Bauelemente-Zuführträgers entspricht und zu den zweiten Fixierflächen für die zweite Richtung und zu der Fixierfläche für die erste Richtung gehört, die der Fixierfläche für die zweite Richtung entspricht.

**16.** Zuführeinrichtung für elektronische Bauelemente nach Anspruch 11, **dadurch gekennzeichnet, dass** in Bezug auf die Bauelemente-Zuführträger-Fixierstange
der Fixierabschnitt für die erste Richtung die Fixierfläche zum Fixieren der Ablageposition in der ersten Richtung ist, indem er in Kontakt mit dem Endabschnitt des Bauelemente-Zuführträgers gebracht wird,
der Fixierabschnitt für die zweite Richtung die Fixierfläche zum Fixieren der Ablageposition in der zweiten Richtung ist, indem er in Kontakt mit dem Endabschnitt des Bauelemente-Zuführträgers gebracht wird, und
die Fixierfläche für die erste Richtung und die Fixierfläche für die zweite Richtung als eine identische Fixierfläche (514a) dienen, die gegenüber der Ablagefläche geneigt ausgebildet ist.

**17.** Verfahren zum Zuführen von elektronische Bauelementen unter Benutzung einer Zuführeinrichtung (100) zum Laden einer Mehrzahl von Paletten (3, 3L, 3S), auf denen je ein Bauelementezuführträger (2, 2L, 2S) zum Tragen einer Mehrzahl von ausgerichteten elektronischen Bauelementen (1) in einer Mehrzahl von gestapelten Schichten angeordnet ist, zum Zuführen der elektronischen Bauelemente auf dem Bauelementezuführträger, der auf einer entladenen Palette angeordnet ist, die aus den beladenen Paletten heraus an eine Zuführposition (107) für elektronische Bauelemente entlang einer Palettenzuführrichtung (A) geführt wird, wobei die Zuführeinrichtung
ein Magazin (4, 4L, 4S) enthält, das eine Mehrzahl von Paaren von Trägersektionen (14) enthält, die in regelmäßigen Abständen in einer Stapelrichtung gebildet sind zum Unterstützen von einander gegenüberliegenden Kantenteilen (3c) der Paletten in einer Richtung rechtwinklig zur der Palettenzuführrichtung, so dass die Paletten etwa horizontal und in der Palettenzuführrichtung beweglich unterstützt werden, und eine Magazintürsektion (22) enthält, die eine zu öffnende Tür in Palettenzuführrichtung an einer Rückseite zum Zuführen und Laden der Paletten von der Rückseite darstellt, zum Laden der durch die entsprechenden Paare von Trägersektionen getragenen Paletten; wobei das Verfahren die folgenden Schritte enthält:

Aufnehmen durch eine Magazinaufnahme (5) zur anhebbaren Aufnahme des Magazins, die einen Palettenzuführport (6) aufweist, damit die in das Magazin geladenen Paletten von der Innenseite des Magazins an eine Zuführposition für elektronische Bauelemente entladen werden können;
Antreiben durch eine Magazinanhebeinheit (8) zum Anheben des Magazins innerhalb der Magazinaufnahme, wobei eine ausgewählte Palette durch den Palettenzuführport entladen werden kann;
Regulieren auf der Vorderseite der Tragepositionen der in das Magazin geladenen Paletten durch ein Regulierglied (18), indem entsprechende Tragesektionen mit einem Kantenabschnitt der Palette auf der Vorderseite in der Palettenzuführrichtung in Kontakt gebracht werden;
Regulieren durch ein Regulierglied (24) auf der Rückseite, das auf einer Innenseite der Magazintürsektion befestigt und in der Palettenzuführrichtung mit der Magazintürsektion bewegbar ist, der Tragpositionen der Paletten, die durch das Regulierglied auf der Vorderseite durch die entsprechenden Tragsektionen durch Inkontaktbringen mit einem Kantenabschnitt der Palette auf der Rückseite in der Palettenzuführrichtung reguliert werden; und
Regulieren durch ein Regulierglied (26) für die horizontale Position, das auf einer Innenseite der Magazintürsektion befestigt ist, der etwa horizontalen Tragposition der Paletten, so dass die Tragposition jeder der Paletten, deren Kantenabschnitte durch die entsprechenden Paare von Tragsektionen getragen werden, die zwischen den in Schichten in dem Magazin gestapelten Paletten angeordnet sind,
wobei die Paletten so geformt sind, dass Konfigurationen eines Kantenabschnitts auf der Vorderseite und eines Kantenabschnitts auf der Rückseite in der Palettenzuführrichtung unterschiedlich geformt sind,
wobei das Regulierglied auf der Rückseite es ermöglicht, das Schließen der Magazintürsektion einzuschränken durch Inkontaktbringen mit dem Kantenabschnitt der Palette, die in einer umgekehrt zur Palettenzuführrichtung gerichteten Tragposition angeordnet ist, und es ermöglicht, die Magazintürsektion in einer Position zu schließen, in der das Regulierglied auf der Rückseite in Kontakt mit dem Kantenabschnitt der Palette gebracht wird, die in der Palettenzuführrichtung vorwärts gerichteten Tragposition in dem Magazin angeordnet ist, wobei das Regulierglied für die horizontale Position es ermöglicht, das Schließen der Magazintürsektion einzuschränken durch Inkontaktbringen mit dem Kantenabschnitt der Palette, die durch die einander nicht gegenüber liegenden Tragsektionen getragen wird, und es ermöglicht, die Magazintürsektion durch Einfügen zwischen die Paletten, die durch das Paar von Tragsektionen in dem Magazin getragen werden, zu schließen, und wobei das Einfügen der Palette, deren Tragposition in dem Magazin unnormal ist, durch die Einschränkung des Schließens der Magazintürsektion festgestellt werden kann.

**Revendications**

1. Dispositif d'alimentation de composants électroniques (100) pour charger une pluralité de palettes (3, 3L, 3S) sur chacune desquelles un plateau d'alimentation de composants (2, 2L, 2S) pour porter une pluralité de composants électroniques (1) agencés de manière alignée sont placés en une pluralité d'étages empilés, pour alimenter les composants électroniques sur le plateau d'alimentation de composants placé sur une palette non chargée parmi les palettes chargées à une position d'alimentation de composants électroniques (107) le long d'une direction d'alimentation de palettes (A), le dispositif d'alimentation comprenant:

un magasin (4, 4L, 4S) qui inclut une pluralité de paires de sections de soutien (14) qui sont formées à intervalles réguliers dans une direction d'empilement, pour soutenir des parties de bordures mutuellement opposées (3c) des palettes dans une direction perpendiculaire à la direction d'alimentation de palettes de sorte que les palettes soient approximativement soutenues horizontalement et de manière mobile dans la direction d'alimentation de palettes et une section de porte de magasin (22) qui est une porte ouvrable pourvue sur un côté arrière dans la direction d'alimentation de palettes pour alimenter et charger les palettes à partir du côté arrière, pour charger les palettes soutenues par les paires correspondantes de sections de soutien;
un récepteur de magasin (5) pour recevoir le magasin en élévation, qui a un orifice d'alimentation de palettes (6) pour permettre aux palettes chargées dans le magasin d'être déchargées de l'intérieur du magasin à une position d'alimentation de composants électroniques;
une unité d'élévation de magasin (8) pour entraîner une élévation du magasin à l'intérieur du récepteur de magasin tout en permettant à une palette sélectionnée d'être déchargée à travers l'orifice d'alimentation de palettes;
un organe de régulation côté avant (18) pour réguler des positions de soutien des palettes chargées dans le magasin par les sections de soutien correspondantes en les amenant en contact avec une partie de bordure de la palette sur un côté avant dans la direction d'alimentation de palettes;
un organe de régulation côté arrière (24), qui est fixé sur une partie intérieure de la section de porte de magasin et mobile dans la direction d'alimentation de palette avec la section de porte de magasin, pour réguler des positions de soutien des palettes régulées par l'organe de régulation côté avant par les sections de soutien correspondantes en les amenant en contact avec une partie de bordure de la palette sur le côté arrière dans la direction d'alimentation de palettes; et
un organe de régulation de posture horizontale (26), qui est fixé sur l'intérieur de la section de porte de magasin, pour réguler la posture de soutien approximativement horizontale des palettes de sorte que la posture de soutien de chacune des palettes, dont des parties de bordures sont soutenues par les paires correspondantes de sections de soutien, soit agencée entre les palettes empilées en étages dans le magasin,
dans lequel les palettes sont formées de sorte que des configurations d'une partie de bordure côté avant et d'une partie de bordure côté arrière dans la direction d'alimentation de palettes soient formées différemment,
l'organe de régulation côté arrière permet de limiter la fermeture de la section de porte de magasin en l'amenant en contact avec la partie de bordure de la palette soutenue dans une posture de soutien dirigée de manière inverse dans la direction d'alimentation de palettes, et permet de fermer la section de porte de magasin dans une position où l'organe de régulation côté arrière est amené en contact avec la partie de bordure de la palette soutenue dans une posture de soutien dirigée vers l'avant dans la direction d'alimentation de palettes dans le magasin,
l'organe de régulation de posture horizontale permet de limiter la fermeture de la section de porte de magasin en l'amenant en contact avec la partie de bordure de la palette soutenue par les sections de soutien qui ne sont pas mutuellement opposées, et permet de fermer la section de porte de magasin par insertion entre les palettes soutenues par la paire de sections de soutien dans le magasin, et
l'inclusion de la palette qui a une anomalie dans sa posture de soutien dans le magasin peut être détectée par la limitation de la fermeture de la section de porte de magasin.

**2.** Dispositif d'alimentation de composants électroniques comme revendiqué dans la revendication 1, comprenant en plus:

un détecteur d'ouverture/de fermeture de porte (28, 29) pour détecter l'état ouvert ou l'état fermé de la section de porte de magasin; et
une section d'affichage d'ouverture et de fermeture de porte (19) pour afficher un résultat de détection par le détecteur d'ouverture/de fermeture de porte tout en permettant à un opérateur de reconnaître le résultat.

**3.** Dispositif d'alimentation de composants électroniques comme revendiqué dans la revendication 2, dans lequel le récepteur de magasin possède une section de porte de réception (20) qui est une porte ouvrable pourvue sur le côté arrière dans la direction d'alimentation de palettes, pour être fermée dans un état dans lequel son intérieur (25) est amené en contact avec l'extérieur de la section de porte de magasin dans l'état fermé, pour être limitée dans sa fermeture en l'amenant en contact avec l'extérieur de la section de porte de magasin pour limiter la fermeture.

**4.** Dispositif d'alimentation de composants électroniques comme revendiqué dans la revendication 3, dans lequel le détecteur d'ouverture/de fermeture de porte (28) est pourvu pour la section de porte de réception.

**5.** Dispositif d'alimentation de composants électroniques comme revendiqué dans la revendication 2, comprenant en plus une unité de commande (9) pour arrêter une opération d'entraînement de l'unité d'élévation de magasin lorsque l'état ouvert de la section de porte de magasin est détecté par le détecteur d'ouverture/de fermeture de porte.

**6.** Dispositif d'alimentation de composants électroniques comme revendiqué dans la revendication 1, dans lequel l'organe de régulation de posture horizontale est pourvu avec une pluralité de projections (26a) qui sont formées agencées dans la direction d'empilement aux mêmes intervalles que les intervalles des sections de soutien, pour être insérées dans des jeux entre les palettes soutenues par la paire de sections de soutien, pour être limitées à s'insérer dans des jeux en les amenant en contact avec le partie de bordure des palettes soutenues par les sections de soutien qui ne sont pas mutuellement opposées.

**7.** Dispositif d'alimentation de composants électroniques comme revendiqué dans la revendication 6, dans lequel l'organe de régulation de posture horizontale est fixé sur la section de porte de magasin de sorte que les projections soient agencées dans des positions situées plus proches de l'une ou l'autre des sections de soutien loin d'un intermédiaire éventuel entre les sections de soutien mutuellement opposées dans un état dans lequel la section de porte de magasin est fermée.

**8.** Dispositif d'alimentation de composants électroniques comme revendiqué dans la revendication 7, dans lequel les projections sont agencées de sorte que l'une quelconque des projections interfère avec la palette soutenue par les sections de soutien qui incluent l'autre section de soutien déplacée par au moins un étage dans la direction d'empilement par rapport à la section de soutien opposée à une section de soutien.

**9.** Dispositif d'alimentation de composants électroniques comme revendiqué dans la revendication 1, dans lequel chacune des palettes possède une partie de saisie de déchargement de palettes (3d), qui a une forme approximativement rectangulaire et est formée approximativement dans une configuration saillante à une partie de bordure (3a) située sur le côté avant dans la direction d'alimentation de palettes, et l'organe de régulation côté arrière est agencé de façon à être capable de se mettre en contact avec la partie de saisie de la palette soutenue dans la posture de soutien dirigée de manière inverse par les sections de soutien.

**10.** Dispositif d'alimentation de composants électroniques comme revendiqué dans la revendication 6, dans lequel les projections de l'organe de régulation de posture horizontale a une dimension de longueur telle que les projections n'atteignent pas un emplacement au-dessus d'une région d'agencement des composants électroniques sur le plateau d'alimentation de composants placés sur chacune des palettes dans un état dans lequel les projections sont insérées dans des jeux entre les palettes.

**11.** Dispositif d'alimentation de composants électroniques comme revendiqué dans la revendication 1, dans lequel le dispositif d'alimentation comprend en plus une barre de fixation de plateau d'alimentation de composants (514, 516, 524, 534, 544, 614, 616) pour fixer le plateau d'alimentation de composants de manière amovible sur une surface de placement (504, 604) de la palette, et la barre de fixation comprenant:

une partie de fixation dans une première direction (514a, 524a, 534a, 544a), pour fixer de manière amovible sa position d'agencement sur la surface de placement, de façon à fixer de manière amovible la position de placement du plateau d'alimentation de composants dans une première direction (direction X ou Y) qui est une direction le long de la surface de placement en étant amenée en contact avec le plateau d'alimentation de composants placé sur la surface de placement;

une partie de fixation dans une deuxième direction (514a, 524c, 534c, 544c), pour fixer de manière amovible sa position d'agencement sur la surface de placement, de façon à fixer de manière amovible la position de placement dans une deuxième direction qui est une direction approximativement perpendiculaire à la surface de placement en étant amenée en contact avec le plateau d'alimentation de composants; et

un organe magnétique formé d'un matériau magnétique sur ou près de sa surface d'agencement sur la surface de placement, pour être fixé sur la surface de placement par une force magnétique de l'organe magnétique.

**12.** Dispositif d'alimentation de composants électroniques comme revendiqué dans la revendication 11, dans lequel, en ce qui concerne la barre de fixation de plateau d'alimentation de composants,

la partie de fixation dans une première direction est la surface de fixation dans une première direction (534a, 544a) formée approximativement perpendiculaire à la position de placement où la position de placement est fixée dans la première direction en étant amenée en contact avec une partie d'extrémité (502a) du plateau d'alimentation de composants, et

la partie de fixation dans une deuxième direction est la surface de fixation dans une deuxième direction (534c, 544c) formée approximativement perpendiculaire à la position de placement où la position de placement est fixée dans la deuxième direction en étant amenée en contact avec une partie d'extrémité du plateau d'alimentation de composants.

**13.** Dispositif d'alimentation de composants électroniques comme revendiqué dans la revendication 12, dans lequel, en ce qui concerne la barre de fixation de plateau d'alimentation de composants,

une position de hauteur de la surface de fixation dans une deuxième direction (544c) amenée en contact avec la partie de bordure du plateau d'alimentation de composants est réglable dans la deuxième direction.

**14.** Dispositif d'alimentation de composants électroniques comme revendiqué dans la revendication 11, dans lequel, en ce qui concerne la barre de fixation de plateau d'alimentation de composants,

la barre de fixation (524) est pourvue d'un organe de poussée (524c) qui pousse constamment la partie de fixation dans une deuxième direction vers la partie d'extrémité du plateau d'alimentation de composants.

**15.** Dispositif d'alimentation de composants électroniques comme revendiqué dans la revendication 12, dans lequel, en ce qui concerne la barre de fixation de plateau d'alimentation de composants,

la barre de fixation (534) comprenant:

une pluralité des surfaces de fixation dans une deuxième direction (534c) formées à des niveaux de hauteurs différents; et

une pluralité des surfaces de fixation dans une première direction (534a) correspondant individuellement aux surfaces de fixation dans une deuxième direction, et

la position de placement du plateau d'alimentation de composants est fixée par la surface de fixation dans une deuxième direction qui est conforme à la hauteur de la partie d'extrémité du plateau d'alimentation de composants et appartient aux surfaces de fixation dans une deuxième direction et la surface de fixation dans une première direction qui correspond à la surface de fixation dans une deuxième direction.

**16.** Dispositif d'alimentation de composants électroniques comme revendiqué dans la revendication 11, dans lequel, en ce qui concerne la barre de fixation de plateau d'alimentation de composants,

la partie de fixation dans une première direction est la surface de fixation dans une première direction pour fixer la position de placement dans la première direction en étant amenée en contact avec la partie d'extrémité du plateau d'alimentation de composants,

la partie de fixation dans une deuxième direction est la surface de fixation dans une deuxième direction pour fixer la position de placement dans la deuxième direction en étant amenée en contact avec la partie d'extrémité du plateau d'alimentation de composants, et

la surface de fixation dans une première direction et la surface de fixation dans une deuxième direction font office de surface de fixation identique (514a) formée inclinée par rapport à la surface de placement.

**17.** Procédé d'alimentation de composants électroniques utilisant un dispositif d'alimentation (100) pour charger une

EP 1 625 780 B1

pluralité de palettes (3, 3L, 3S) sur chacune desquelles un plateau d'alimentation de composants (2, 2L, 2S) pour porter une pluralité de composants électroniques (1) agencés de manière alignée sont placés en une pluralité d'étages empilés, pour alimenter les composants électroniques sur le plateau d'alimentation de composants placé sur une palette non chargée parmi les palettes chargées à une position d'alimentation de composants électroniques (107) le long d'une direction d'alimentation de palettes (A), où le dispositif d'alimentation comprend un magasin (4, 4L, 4S) qui inclut une pluralité de paires de sections de soutien (14) qui sont formées à intervalles réguliers dans une direction d'empilement, pour soutenir des parties de bordures mutuellement opposées (3c) des palettes dans une direction perpendiculaire à la direction d'alimentation de palettes de sorte que les palettes soient soutenues approximativement horizontalement et de manière mobile dans la direction d'alimentation de palettes et une section de porte de magasin (22) qui est une porte ouvrable pourvue sur un côté arrière dans la direction d'alimentation de palettes pour alimenter et charger les palettes à partir du côté arrière, pour charger les palettes soutenues par les paires correspondantes de sections de soutien, le procédé comprenant les étapes de:

recevoir, par un récepteur de magasin (5), le magasin en élévation, qui a un orifice d'alimentation de palettes (6) pour permettre aux palettes chargées dans le magasin d'être déchargées de l'intérieur du magasin à une position d'alimentation de composants électroniques;

entraîner, par une unité d'élévation de magasin (8), une élévation du magasin à l'intérieur du récepteur de magasin tout en permettant à une palette sélectionnée d'être déchargée à travers l'orifice d'alimentation de palettes;

réguler, par un organe de régulation côté avant (18), des positions de soutien des palettes chargées dans le magasin par les sections de soutien correspondantes en les mettant en contact avec une partie de bordure de la palette sur un côté avant dans la direction d'alimentation de palettes;

réguler, par un organe de régulation côté arrière (24), qui est fixé sur une partie intérieure de la section de porte de magasin et mobile dans la direction d'alimentation de palettes avec la section de porte de magasin, des positions de soutien des palettes régulées par l'organe de régulation côté avant par les sections de soutien correspondantes en les mettant en contact avec une partie de bordure de la palette sur le côté arrière dans la direction d'alimentation de palettes; et

réguler, par un organe de régulation de posture horizontale (26), qui est fixé sur l'intérieur de la section de porte de magasin, la posture de soutien approximativement horizontale des palettes de sorte que la posture de soutien de chacune des palettes, dont des parties de bordures sont soutenues par les paires correspondantes de sections de soutien, soit agencée entre les palettes empilées en étages dans le magasin,

dans lequel les palettes sont formées de sorte que des configurations d'une partie de bordure côté avant et d'une partie de bordure côté arrière dans la direction d'alimentation de palettes soient formées différemment, l'organe de régulation côté arrière permet de limiter la fermeture de la section de porte de magasin en l'amenant en contact avec la partie de bordure de la palette soutenue dans une posture de soutien dirigée de manière inverse dans la direction d'alimentation de palettes, et permet de fermer la section de porte de magasin dans une position où l'organe de régulation côté arrière est amené en contact avec la partie de bordure de la palette soutenue dans une posture de soutien dirigée vers l'avant dans la direction d'alimentation de palettes dans le magasin,

l'organe de régulation de posture horizontale permet de limiter la fermeture de la section de porte de magasin en l'amenant en contact avec la partie de bordure de la palette soutenue par les sections de soutien qui ne sont pas mutuellement opposées, et permet de fermer la section de porte de magasin en l'insérant entre les palettes soutenues par la paire de sections de soutien dans le magasin, et

l'inclusion de la palette qui a une anomalie dans sa posture de soutien dans le magasin peut être détectée par la limitation de la fermeture de la section de porte de magasin.

*Fig.1*

*Fig. 2*

Fig. 3

*Fig. 4*

Fig. 5

EP 1 625 780 B1

Fig. 6

EP 1 625 780 B1

*Fig. 7A*

*Fig. 7B*

*Fig. 8A*

*Fig. 8B*

Fig. 9

EP 1 625 780 B1

Fig. 10

EP 1 625 780 B1

Fig. 11

Fig. 12

*Fig.13A*

*Fig.13B*

EP 1 625 780 B1

*Fig.14A*

*Fig.14B*

EP 1 625 780 B1

## Fig.15

## Fig.16

*Fig.17*

502
502a
524c
524c
524
524b
504
524a

*Fig.18*

534c   534a   534
534b
502
504
502a

*Fig.19*

544c   544
544b
502
502a   544a   504

Fig.20A

Fig.20B

EP 1 625 780 B1

**Fig. 21**

554

553

556

552

551

556

557

555

**Fig. 22**

552    556    556a

556b

554

**Fig. 23**

566

566a    566b

554

*Fig.* 24

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11121985 A
- JP 2001326495 A